# EUROPEAN PATENT SPECIFICATION

(11) **EP 2 034 551 B1**
(45) Date of publication and mention of the grant of the patent: **16.05.2012**
(21) Application number: 07740735.1
(22) Date of filing: 30.03.2007
(51) Int. Cl.: H01P 1/203, H01P 1/205

(54) **BANDPASS FILTER, HIGH-FREQUENCY MODULE USING THE SAME, AND RADIO COMMUNICATION DEVICE USING THEM**
BANDPASSFILTER, HOCHFREQUENZMODUL DAMIT UND FUNKKOMMUNIKATIONSEINRICHTUNG DAMIT
FILTRE PASSE-BANDE, MODULE HAUTE FRÉQUENCE L'UTILISANT ET DISPOSITIF DE COMMUNICATION LES UTILISANT

(30) Priority: 29.05.2006 JP 2006148575; 10.10.2006 JP 2006276133; 13.10.2006 JP 2006279482
(43) Date of publication of application: 11.03.2009
(73) Proprietor: Kyocera Corporation, Fushimi-ku Kyoto-shi Kyoto (JP)
(72) Inventor: YOSHIKAWA, Hiromichi, Kirishima-shi Kagoshima 899-4396 (JP)
(74) Representative: Beetz & Partner
(86) International application number: PCT/JP2007/057299
(87) International publication number: WO 2007/138783

(56) References cited:
- EP-A- 1 094 538
- EP-A- 1 265 311
- EP-A- 1 513 217
- JP-A- 10 117 104
- JP-A- 10 145 105
- JP-A- 10 190 308
- JP-A- 11 088 009
- JP-A- 61 258 503
- JP-A- 2005 159 512
- JP-U- 01 146 603

## Description

### Technical Field

The present invention relates to a bandpass filter, a high frequency module using the bandpass filter, and a radio communication device using the bandpass filter and the high frequency module, and more particularly, to a bandpass filter that may be preferably used for UWB (Ultra Wide Band) and has a very broad pass bandpassband, a high frequency module using the bandpass filter, and a radio communication device using the bandpass filter and the high frequency module.

### Background Art

In recent years, UWB (Ultra Wide Band) draws attention as a new communication means. UWB performs transmission of huge amounts of data using a broad frequency band over a short distance such as 10 m, and for example, a frequency band of 3.1 to 10.6 GHz is subjected to use for UWB according to the rule of U.S. FCC (Federal Communications Commission). As such, a feature of UWB is to utilize a very broad frequency band. Japan and the ITU-R have a plan to introduce standards separated into a low band using a band of about 3.1 to 4.7 GHz and a high band using a band of about 6 GHz to 10.6 GHz to avoid a band of 5.3 GHz that is used in the IEEE802.11a. Accordingly, a low band filter requires the characteristic of being abruptly attenuated in 2.5 GHz and 5.3 GHz.

Recently, ultra wideband filters usable for UWB have been actively studied as a consequence, there is a report that a wideband characteristic in which a passbandpassband width exceeds 100% by the relative bandwidth (bandwidth/center frequency), may be obtained by a bandpass filter to which the principle of a directional coupler is applied (for example, refer to a non-patent document, "An Ultra-Wideband Bandpass filter Using Broadside-Coupled Microstrip-Coplanar Waveguide Structure", IEICE Transactions, No. C-2-114, p.147, Mar. 2005).

In the meanwhile, there has been known a bandpass filter that has been conventionally used widely, which is configured as a plurality of 1/4 wavelength strip line resonators that are coupled with each other (for example, refer to Japanese Patent Application Laid-Open No. 2004-180032).

In addition, there has been known a laminated dielectric filter that has a construction in that a plurality of resonator inner conductors (1/4 wavelength strip line resonator) which is arranged in an interdigital type such that a short-circuited end and an open end thereof become different to each other, and a short-circuited end connection pattern is buried in another layer different from the layer in which each of the resonator inner conductors are formed, the short-circuited end connection pattern connecting between resonator outer conductors located near the short-circuited end of the adjacent resonator inner conductor(for example, see Japanese Patent Application Laid-Open No. 11-88009).

However, the above-mentioned bandpass filters had their own problems and therefore were not appropriate for the bandpass filter for UWB.

For example, the bandpass filter suggested in the non-patent document had a problem that its passbandpassband width is too broad. That is, UWB has been originally planned to use a frequency band of 3.1 GHz to 4.9 GHz despite that it finally employs a frequency bandwidth of 3.1 GHz to 10.6 GHz, and therefore, its relative bandwidth corresponds to 45%. Accordingly, a filter used for UWB requires the passbandpassband width of about 30% by the relative bandwidth. In addition, it is necessary to consider effects from W-LAN (IEEE802.11a), and thus, attenuation is required in 5.15 GHz. Accordingly, the bandpass filter suggested in the non-patent document, which has a characteristic that the passbandpassband width exceeds 100% by the relative bandwidth, could not be used since the passbandpassband width was too broad.

Furthermore, the bandpass filter using the conventional 1/4 wavelength resonator had a too narrow passbandpassband width, and the pass bandpassband of the bandpass filter disclosed in the Japanese Patent Application Laid-Open No. 2004-180032, which has been adapted to have a wideband, did not reach even the passbandpassband width of 10% by the relative bandwidth. Therefore, this could not be used as the bandpass filter for UWB which requires a broad passbandpassband width of more than 30% by the relative bandwidth.

Moreover, the bandpass filter disclosed in the Japanese Patent Application Laid-Open No. 11-88009 could create only a single attenuation pole at either one of lower band side or higher band side than the pass bandpassband therefore, this could not be used as the bandpass filter for UWB in which both sides of the pass bandpassband need to be abruptly attenuated.

Besides the above mentioned prior art, EP- A-1265311 discloses a laminated bandpass filter which comprises an integrated device formed by laminating and integrating a plurality of dielectric layers together, a plurality of internal grounding conductors and two bandpass filters sandwiched between two of the plurality of grounding conductors. The two bandpass filters are formed in different areas with a boundary between these areas corresponding to a predetermined cross section substantially perpendicular to the grounding conductors.

JP-A-61258503 discloses a strip line filter with small size and low cost by coupling respectively a first and second input/output electrodes to a prescribed resonator electrode and further coupling the first and second input/output electrodes to form an attenuation pole.

### Disclosure of the Invention

The present invention has been designed to solve the problems of the prior art, and an object of the present invention is to provide a bandpass filter that has a passbandpassband width appropriate as a bandpass filter for UWB, a high frequency module using the bandpass filter, and a radio communication device using them.

The present invention relates to a bandpass filter according to claim 1 and the dependent claims.

The present invention relates to a high frequency module including the bandpass filter disclosed in claim 1. A radio communication device with the bandpass filter of claim 1 is also disclosed.

A bandpass filter according to the present invention includes a plurality of strip-shaped resonance electrodes, each of which has an end connected to the ground potential and functions as a 1/4 wavelength resonator. The resonance electrodes are arranged on a first inter-layer portion of the laminate in parallel with each other to be electromagnetically coupled with each other, and so that one end of each of the resonance electrodes is alternate to the other end of its adjacent resonance electrode. Since the one end of each of the resonance electrodes is alternate to the other end of its adjacent resonance electrode, the plurality of resonance electrodes are coupled with each other in an inter-digital type, and therefore, a coupling by magnetic fields is added to a coupling by electric fields, and this makes the coupling stronger than when they are coupled with each other in a comb-line type. By doing so, the frequency interval between resonance frequencies in each resonance mode is adapted to be appropriate to achieve a broad passbandpassband width of 40% by the relative bandwidth that is very appropriate as a bandpass filter for UWB that is well in excess of the region that may be realized by the conventional filter using the 1/4 wavelength resonator.

According to the present invention, the input coupling electrode is arranged to face the resonance electrode over the region of more than half of the length of the resonance electrode of the input stage, wherein a position of the input coupling electrode where an electrical signal inputted from an external circuit is supplied is located closer to the other end of the resonance electrode of the input stage than the center of the input coupling electrode in the longitudinal direction, and the output coupling electrode is arranged to face the resonance electrode of the output stage over more than half of the length of the resonance electrode of the output stage, wherein a position of the output coupling electrode where an electrical signal outputted to the external circuit is drawn is located closer to the other end of the resonance electrode of the output stage than the center of the output coupling electrode in the longitudinal direction. Since the input coupling electrode and the resonance electrode of the input stage are coupled with each other in an inter-digital type and similarly the output coupling electrode and the resonance electrode of the output stage are coupled with each other in an inter-digital type by this construction, a coupling by magnetic fields is added to a coupling by electric fields, and this leads to a stronger coupling similarly to the relationship between the resonance electrodes as described above. This realizes a bandpass filter having a flat and low-loss transmission characteristicstransmission characteristic over the entire region of the wide pass bandpassband as well as not having a great increase of insertion loss in frequencies between resonance frequencies in each resonance mode even in the pass bandpassband significantly exceeding a region that may be realized by the conventional filter using the 1/4 wavelength resonator.

According to the present invention, an annular ground electrode formed on the first inter-layer portion to surround the plurality of resonance electrodes, wherein one end of each of the plurality of resonance electrodes is connected to the annular ground electrode that is connected to the ground potential, may be included. One end of each of the resonance electrodes alternately arranged to each other may be easily connected to the ground potential since there exists electrodes connected to the ground potential at both sides of each resonance electrode in the longitudinal direction.

According to the present invention, a plurality of auxiliary resonance electrodes, each of which corresponds to each of the plurality of resonance electrodes, being arranged to have a region facing the annular ground electrode, wherein the auxiliary resonance electrode is connected to the resonance electrode through a first penetration conductor, may be included. Capacitance is generated between each auxiliary resonance electrode and the annular ground electrode facing each other, so that the length of each resonance electrode may be shortened, thus enabling a small-size bandpass filter.

According to the present invention, an auxiliary input coupling electrode arranged to have a region facing the auxiliary resonance electrode connected to the resonance electrode of the input stage to be connected to the input coupling electrode; and an auxiliary output coupling electrode arranged to have a region facing the auxiliary resonance electrode connected to the resonance electrode of the output stage to be connected to the output coupling electrode, may be included. An electromagnetic coupling is created between the auxiliary resonance electrode connected to the resonance electrode of the input stage and the auxiliary input coupling electrode, and this is added to the electromagnetic coupling between the resonance electrode of the input stage and the input coupling electrode. Similarly, an electromagnetic coupling is created between the auxiliary resonance electrode connected to the resonance electrode of the output stage and the auxiliary output coupling electrode, and this is added to the electromagnetic coupling between the resonance electrode of the output stage and the output coupling electrode. Accordingly, the electromagnetic coupling between the input coupling electrode and the resonance electrode of the input stage and the electromagnetic coupling between the output coupling electrode and the resonance electrode of the output stage become further stronger. Therefore, it may be possible to achieve a bandpass filter having further reduced increase of insertion loss at frequencies between resonance frequencies in each resonance mode and having a flatter and lower-loss transmission characteristicstransmission characteristic over the entire region of the broad pass bandpassband even in the very broad passbandpassband width.

In addition, since the auxiliary input coupling electrode is connected to a portion of the input coupling electrode, which is nearer the other end of the resonance electrode of the input stage than the center of the input coupling electrode in the longitudinal direction, through a second penetration conductor, and similarly, the auxiliary output coupling electrode is connected to a portion of the output coupling electrode, which is nearer the other end of the resonance electrode of the output stage than the center of the output coupling electrode in the longitudinal direction through a third penetration conductor, the input coupling electrode and the resonance electrode of the input stage are coupled with each other in the inter-digital type and the output coupling electrode and the resonance electrode of the output stage are coupled with each other in the inter-digital type in a case where an electrical signal externally inputted is supplied to the input coupling electrode through the auxiliary input coupling electrode and an electrical signal drawn from the output coupling electrode is outputted to an external circuit through the auxiliary output coupling electrode, and therefore, thus making it possible to create a strong coupling obtained by addition of the coupling by magnetic fields and the coupling by electric fields.

The bandpass filter according to the present invention includes strip-shaped four or more resonance electrodes arranged on a first inter-layer portion of a laminate in parallel with each other to be electromagnetically coupled with each other, wherein one end of each of the resonance electrodes is connected to the ground potential so that the resonance electrode functions as a 1/4 wavelength resonator, and one end of each of the resonance electrodes is alternate to the other end of its adjacent resonance electrode. Since the one end of each of the four or more resonance electrodes is arranged alternately to the other end of its adjacent resonance electrode, and thus, the resonance electrodes are coupled with each other in the inter-digital type, a coupling by magnetic fields and a coupling by electric fields are added to each other, thus making the coupling stronger compared to when they are coupled with each other in the comb-line type. By doing so, the frequency interval between resonance frequencies in each resonance mode becomes appropriate to obtain a broad passbandpassband width that reaches 30% by the relative bandwidth that is fairly suitable as a bandpass filter for UWB and is well in excess of the region that may be realized by the conventional filter using the 1/4 wavelength resonator.

Since the resonance electrode of the input stage and the resonance electrode of the output stage are coupled with each other through a resonance electrode coupling conductor whose both ends are connected to the ground potential, an inductive coupling is made between the resonance electrode of the input stage and the resonance electrode of the output stage. Further, a capacitive coupling is made between two adjacent resonant electrodes of the four or more resonance electrodes, thus making it possible to realize a so-called pseudo elliptic function filter or elliptic function filter. Therefore, attenuation poles may be formed at both sides of the filter.

According to the present invention, the input coupling electrode is arranged to face the resonance electrode over the region of more than half of the length of the resonance electrode of the input stage, wherein a position of the input coupling electrode where an electrical signal inputted from an external circuit is supplied is located closer to the other end of the resonance electrode of the input stage than the center of the input coupling electrode in the longitudinal direction, and the output coupling electrode is arranged to face the resonance electrode of the output stage over more than half of the length of the resonance electrode of the output stage, wherein a position of the output coupling electrode where an electrical signal outputted to the external circuit is drawn is located closer to the other end of the resonance electrode of the output stage than the center of the output coupling electrode in the longitudinal direction. Since the input coupling electrode and the resonance electrode of the input stage are coupled with each other in an inter-digital type and similarly the output coupling electrode and the resonance electrode of the output stage are coupled with each other in an inter-digital type by this construction, a coupling by magnetic fields is added to a coupling by electric fields, and this leads to a stronger coupling similarly to the relationship between the resonance electrodes as described above. This realizes a bandpass filter having a flat and low-loss transmission characteristicstransmission characteristic over the entire region of the wide pass bandpassband as well as not having great increase in insertion loss at frequencies between resonance frequencies in each resonance mode even in the pass bandpassband that is well in excess of a region that may be realized by the conventional filter using the 1/4 wavelength resonator.

According to the present invention, an annular ground electrode formed on the first inter-layer portion to surround the peripheries of the four or more resonance electrodes, wherein one end of each of the resonance electrodes is connected to the annular ground electrode that is connected to the ground potential, may be included. One end of each of the resonance electrodes alternately arranged to each other may be easily connected to the ground potential since there exists electrodes connected to the ground potential at both sides of each resonance electrode in the longitudinal direction.

According to the present invention, a plurality of auxiliary resonance electrodes, each of which corresponds to each of the four or more resonance electrodes, being arranged to have a region facing the annular ground electrode, wherein the auxiliary resonance electrode is connected to the resonance electrode through a second penetration conductor, may be included. Capacitance is generated between each auxiliary resonance electrode and the annular ground electrode facing each other, so that the length of each resonance electrode may be shortened, thus enabling a small-size bandpass filter.

According to the present invention, an auxiliary input coupling electrode arranged to have a region facing the auxiliary resonance electrode connected to the resonance electrode of the input stage to be connected to the input coupling electrode; and an auxiliary output coupling electrode arranged to have a region facing the auxiliary resonance electrode connected to the resonance electrode of the output stage to be connected to the output coupling electrode, may be included. An electromagnetic coupling is created between the auxiliary resonance electrode connected to the resonance electrode of the input stage and the auxiliary input coupling electrode, and this is added to the electromagnetic coupling between the resonance electrode of the input stage and the input coupling electrode. Similarly, an electromagnetic coupling is created between the auxiliary resonance electrode connected to the resonance electrode of the output stage and the auxiliary output coupling electrode, and this is added to the .electromagnetic coupling between the resonance electrode of the output stage and the output coupling electrode. Accordingly, the electromagnetic coupling between the input coupling electrode and the resonance electrode of the input stage and the electromagnetic coupling between the output coupling electrode and the resonance electrode of the output stage become further stronger. Therefore, it may be possible to achieve a bandpass filter having further reduced increase of insertion loss at frequencies between resonance frequencies in each resonance mode and having a flatter and lower-loss transmission characteristicstransmission characteristic over the entire region of the broad pass bandpassband even in the very broad passbandpassband width.

In addition, since the auxiliary input coupling electrode is connected to a portion of the input coupling electrode, which is nearer the other end of the resonance electrode of the input stage than the center of the input coupling electrode in the longitudinal direction, through a third penetration conductor, and similarly, the auxiliary output coupling electrode is connected to a portion of the output coupling electrode, which is nearer the other end of the resonance electrode of the output stage than the center of the output coupling electrode in the longitudinal direction through a fourth penetration conductor, the input coupling electrode and the resonance electrode of the input stage are coupled with each other in the inter-digital type and the output coupling electrode and the resonance electrode of the output stage are coupled with each other in the inter-digital type in a case where an electrical signal externally inputted is supplied to the input coupling electrode through the auxiliary input coupling electrode and an electrical signal drawn from the output coupling electrode is outputted to an external circuit through the auxiliary output coupling electrode, and therefore, thus making it possible to create a strong coupling obtained by addition of the coupling by magnetic fields and the coupling by electric fields.

The bandpass filter according to the present invention includes strip-shaped first four or more resonance electrodes arranged on a first inter-layer portion of a laminate in parallel with each other to be electromagnetically coupled with each other, wherein one end of each of the first resonance electrodes is connected to the ground potential so that the resonance electrode functions as a 1/4 wavelength resonator, and one end of each of the first resonance electrodes is alternate to the other end of its adjacent resonance electrode. Since the one end of each of the four or more first resonance electrodes is arranged alternately to the other end of its adjacent resonance electrode, and thus, the first resonance electrodes are coupled with each other in the inter-digital type, a coupling by magnetic fields and a coupling by electric fields are added to each other, thus making the coupling stronger compared to when they are coupled with each other in the comb-line type. By doing so, the frequency interval between resonance frequencies in each resonance mode becomes appropriate to obtain a broad passbandpassband width that reaches 30% by the relative bandwidth that is fairly suitable as a bandpass filter for UWB and is well in excess of the region that may be realized by the conventional filter using the 1/4 wavelength resonator.

Since the resonance electrode of the input stage and the resonance electrode of the output stage are coupled with each other through a resonance electrode coupling conductor whose both ends are connected to the ground potential, an inductive coupling is made between the resonance electrode of the input stage and the resonance electrode of the output stage. Further, a capacitive coupling is made between two adjacent resonant electrodes of the four or more first resonance electrodes, thus making it possible to realize a so-called pseudo elliptic function filter or elliptic function filter. Therefore, attenuation poles may be formed at both sides of the filter (at the lower band side and the higher band side than the pass bandpassband).

In addition, this functions as a counteraction resonator (notch filter). Since one or more resonance electrode is provide which has a resonance frequency near the cutoff frequency outside the pass bandpassband, the attenuation pole is further created between the attenuation formed by the resonance coupling conductor and the cutoff frequency, thus making it possible to obtain a more abrupt attenuation characteristic.

According to the present invention, the input coupling electrode is arranged to face the resonance electrode over the region of more than half of the length of the resonance electrode of the input stage, wherein a position of the input coupling electrode where an electrical signal inputted from an external circuit is supplied is located closer to the other end of the resonance electrode of the input stage than the center of the input coupling electrode in the longitudinal direction, and the output coupling electrode is arranged to face the resonance electrode of the output stage over more than half of the length of the resonance electrode of the output stage, wherein a position output coupling electrode where an electrical signal outputted to the external circuit is drawn is located closer to the other end of the resonance electrode of the output stage than the center of the output coupling electrode in the longitudinal direction. Since the input coupling electrode and the resonance electrode of the input stage are coupled with each other in an inter-digital type and similarly the output coupling electrode and the resonance electrode of the output stage are coupled with each other in an inter-digital type by this construction, a coupling by magnetic fields is added to a coupling by electric fields, and this leads to a stronger coupling similarly to the relationship between the resonance electrodes as described above. This realizes a bandpass filter having a flat and low-loss transmission characteristicstransmission characteristic over the entire region of the wide pass bandpassband as well as not having great increase in insertion loss at frequencies between resonance frequencies in each resonance mode even in the pass bandpassband that is well in excess of a region that may be realized by the conventional filter using the 1/4 wavelength resonator.

According to the present invention, an annular ground electrode formed on the first inter-layer portion to surround the peripheries of the four or more resonance electrodes, wherein one end of each of the resonance electrodes is connected to the annular ground electrode that is connected to the ground potential, may be included. One end of each of the resonance electrodes alternately arranged to each other may be easily connected to the ground potential since there exists electrodes connected to the ground potential at both sides of each resonance electrode in the longitudinal direction.

According to the present invention, a plurality of auxiliary resonance electrodes, each of which corresponds to each of the four or more resonance electrodes, being arranged to have a region facing the annular ground electrode, wherein the auxiliary resonance electrode is connected to the resonance electrode through a third penetration conductor, may be included. Capacitance is generated between each auxiliary resonance electrode and the annular ground electrode facing each other, so that the length of each resonance electrode may be shortened, thus enabling a small-size bandpass filter.

According to the present invention, an auxiliary input coupling electrode arranged to have a region facing the auxiliary resonance electrode connected to the resonance electrode of the input stage to be connected to the input coupling electrode; and an auxiliary output coupling electrode arranged to have a region facing the auxiliary resonance electrode connected to the resonance electrode of the output stage to be connected to the output coupling electrode, may be included. An electromagnetic coupling is created between the auxiliary resonance electrode connected to the resonance electrode of the input stage and the auxiliary input coupling electrode, and this is added to the electromagnetic coupling between the resonance electrode of the input stage and the input coupling electrode. Similarly, an electromagnetic coupling is created between the auxiliary resonance electrode connected to the resonance electrode of the output stage and the auxiliary output coupling electrode, and this is added to the electromagnetic coupling between the resonance electrode of the output stage and the output coupling electrode. Accordingly, the electromagnetic coupling between the input coupling electrode and the resonance electrode of the input stage and the electromagnetic coupling between the output coupling electrode and the resonance electrode of the output stage become further stronger. Therefore, it may be possible to achieve a bandpass filter having further reduced increase of insertion loss at frequencies between resonance frequencies in each resonance mode and having a flatter and lower-loss transmission characteristicstransmission characteristic over the entire region of the broad pass bandpassband even in the very broad passbandpassband width.

In addition, since the auxiliary input coupling electrode is connected to a portion of the input coupling electrode, which is nearer the other end of the resonance electrode of the input stage than the center of the input coupling electrode in the longitudinal direction, through a fourth penetration conductor, and similarly, the auxiliary output coupling electrode is connected to a portion of the output coupling electrode, which is nearer the other end of the resonance electrode of the output stage than the center of the output coupling electrode in the longitudinal direction through a fifth penetration conductor, the input coupling electrode and the resonance electrode of the input stage are coupled with each other in the inter-digital type and the output coupling electrode and the resonance electrode of the output stage are coupled with each other in the inter-digital type in a case where an electrical signal externally inputted is supplied to the input coupling electrode through the auxiliary input coupling electrode and an electrical signal drawn from the output coupling electrode is outputted to an external circuit through the auxiliary output coupling electrode, and therefore, thus making it possible to create a strong coupling obtained by addition of the coupling by magnetic fields and the coupling by electric fields.

A high frequency module and a radio communication device according to the present invention employs the bandpass filter according to the present invention for filtering of a receipt signal and a transmission signal, which has a low loss with respect to signals passing over the entire region of a pass bandpassband. Since the receipt signal and the transmission signal passing the bandpass filter have reduced attenuation, the receipt sensitivity is improved, and since the amplification degree of the receipt signal and the transmission signal may be decreased, the consumption power is lessened in an amplification circuit. This realizes a high-capacity high frequency module and radio communication device that has a high receipt sensitivity and low consumption power.

### Brief Description of the Drawings

The objects, features, and advantages of the present invention will be apparent from the following detailed descriptions and accompanying drawings.
Fig. 1 is a perspective view schematically illustrating the external appearance of a bandpass filter according to a first embodiment of the present invention.
Fig. 2 is an exploded perspective view schematically illustrating the bandpass filter shown in Fig. 1.
Figs. 3A to 3E are plan views schematically illustrating an upper surface, a lower surface, and inter-layer portions of the bandpass filter shown in Fig. 1.
Fig. 4 is a cross sectional view taken along the line A-A' shown in Fig. 1.
Fig. 5 is a perspective view schematically illustrating the external appearance of a bandpass filter according to a second embodiment of the present invention.
Fig. 6 is an exploded perspective view schematically illustrating the bandpass filter shown in Fig. 5.
Figs. 7A to 7F are plan views schematically illustrating an upper surface, a lower surface, and inter-layer portions of the bandpass filter shown in Fig. 5.
Fig. 8 is a cross sectional view taken along the line A-A' shown in Fig. 5.
Fig. 9 is a perspective view schematically illustrating the external appearance of a bandpass filter according to a third embodiment of the present invention.
Fig. 10 is an exploded perspective view schematically illustrating the bandpass filter shown in Fig. 9.
Figs. 11A to 11ZH are plan views schematically illustrating an upper surface, a lower surface, and inter-layer portions of the bandpass filter shown in Fig. 9.
Fig. 12 is a cross sectional view taken along the line A-A' shown in Fig. 9.
Fig. 13 is an exploded perspective view schematically illustrating the external appearance of a bandpass filter according to a fourth embodiment of the present invention.
Fig. 14 is an exploded perspective view schematically illustrating the external appearance of a bandpass filter according to a fifth embodiment of the present invention.
Fig. 15 is an exploded perspective view schematically illustrating the external appearance of a bandpass filter according to a sixth embodiment of the present invention.
Fig. 16 is an exploded perspective view schematically illustrating the external appearance of a bandpass filter according to a seventh embodiment of the present invention.
Figs. 17A and 17B are views illustrating the bandpass filters shown in Figs. 15 and 16, respectively.
Fig. 18 is an exploded perspective view schematically illustrating the external appearance of a bandpass filter according to an eighth embodiment of the present invention.
Fig. 19 is an exploded perspective view schematically illustrating the external appearance of a bandpass filter according to a ninth embodiment of the present invention.
Fig. 20 is an exploded perspective view schematically illustrating the external appearance of a bandpass filter according to a tenth embodiment of the present invention.
Fig. 21 is a block diagram illustrating a constructional example of a high frequency module and a radio communication device using the high frequency module according to an eleventh embodiment of the present invention, which employ the bandpass filter according to the present invention.
Fig. 22 is an exploded perspective view schematically illustrating a first variation to the bandpass filter according to the present invention.
Fig. 23 is an exploded perspective view schematically illustrating a second variation to the bandpass filter according to the present invention.
Fig. 24 is a view illustrating a result of simulation regarding an electrical characteristic of the bandpass filter according to the present invention.
Fig. 25 is a view illustrating a result of simulation regarding a transmission characteristic of the bandpass filter according to the present invention, which is shown in Fig. 15.
Fig. 26 is a view illustrating a result of simulation regarding a transmission characteristic of the bandpass filter shown in Fig. 15, in which the resonance electrode coupling conductor has been removed.
Fig. 27 is a view illustrating a result of simulation regarding a transmission characteristic of an example of the bandpass filter according to the present invention, which is shown in Fig. 20.
Fig. 28 is a view illustrating a result of simulation regarding a transmission characteristic of another example of the bandpass filter according to the present invention, which is shown in Fig. 20.
Fig. 29 is a view illustrating a result of simulation regarding a transmission characteristic of another example of the bandpass filter according to the present invention, which is shown in Fig. 17A and Fig. 17B.
Fig. 30 is a view illustrating a result of simulation regarding a transmission characteristic of another example of the bandpass filter according to the present invention, which is shown in Fig. 18.
Fig. 31 is a view illustrating a result of simulation regarding a transmission characteristic of the bandpass filter shown in Fig. 20, in which a second resonance electrode coupling conductor has been removed.

### Best Mode for Carrying out the Invention

Hereinafter, embodiments of the present invention will be described in detail with reference to accompanying drawings. Hereinafter, a bandpass filter according to the present invention, a high frequency module using the bandpass filter, and a radio communication device using the bandpass filter and the high frequency module will be described in detail with reference to accompanying drawings.

### (First Embodiment)

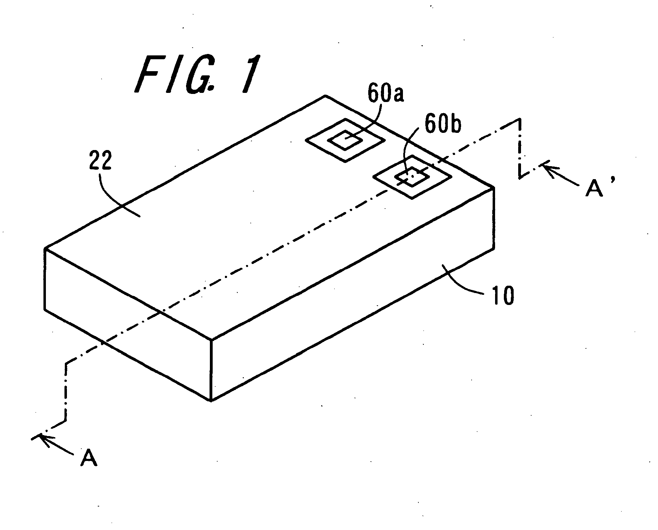

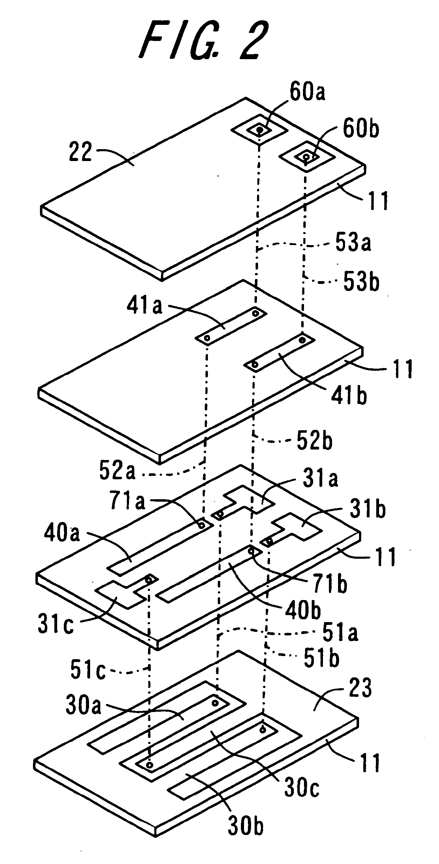

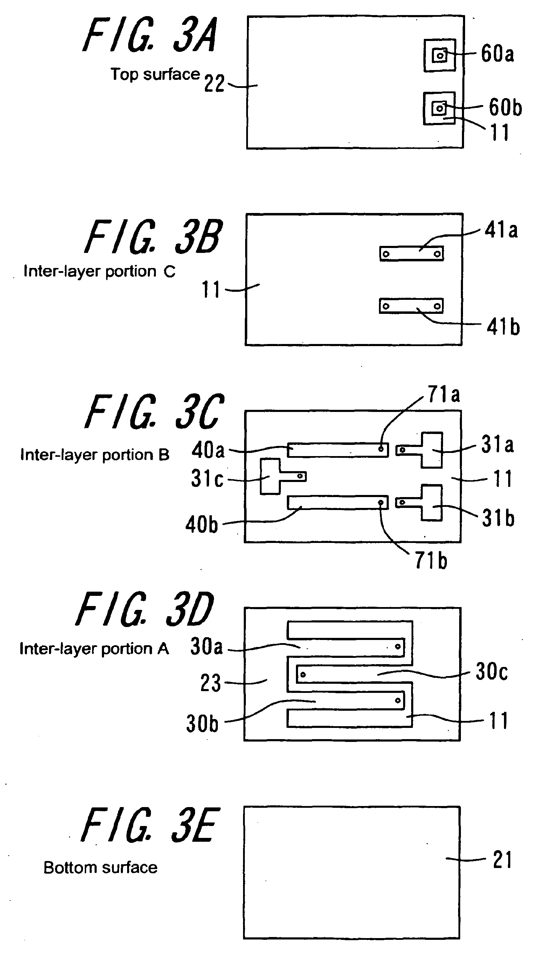

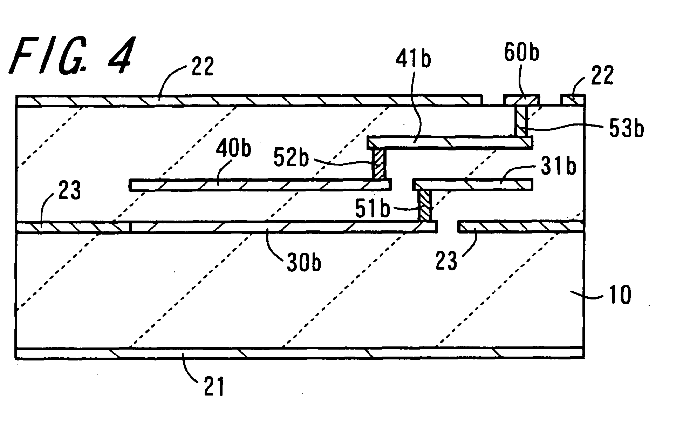

Fig. 1 is a perspective view schematically illustrating the external appearance of a bandpass filter according to a first embodiment of the present invention. Fig. 2 is an exploded perspective view schematically illustrating the bandpass filter shown in Fig. 1. Figs. 3A to 3E are plan views schematically illustrating an upper surface, a lower surface, and inter-layer portions of the bandpass filter shown in Fig. 1. Fig. 4 is a cross sectional view taken along the line A-A' shown in Fig. 1.

The bandpass filter according to the first embodiment includes a laminate 10 which is formed by stacking a plurality of dielectric layers 11; a first ground electrode 21 arranged on the bottom surface of the laminate 10; a second ground electrode 22 arranged on the top surface of the laminate 10; strip-shaped resonance electrodes 30a, 30b, and 30c arranged on an inter-layer portion A of the laminate 10 in parallel with each other; an annular ground electrode 23 shaped as a ring on the inter-layer portion A of the laminate 10 to surround the resonance electrodes 30a, 30b, and 30c and to which one end of each of the resonance electrodes 30a, 30b, and 30c is connected; a strip-shaped input coupling electrode 40a arranged on another inter-layer portion B of the laminate 10 to face the resonance electrode 30a of an input stage; a strip-shaped output coupling electrode 40b arranged on the inter-layer portion B of the laminate 10 to face the resonance electrode 30b of an output stage; auxiliary resonance electrodes 31a, 31b, and 31c arranged on the inter-layer portion B of the laminate 10 to face the annular ground electrode 23 and connected to the resonance electrodes 30a, 30b, and 30c, respectively, by first penetration conductors 51a, 51b, and 51c, respectively, which penetrate the dielectric layer 11; an auxiliary input coupling electrode 41a arranged on another inter-layer portion C of the laminate 10 to face the auxiliary resonance electrode 31a and connected to the input coupling electrode 40a of the input stage by a second penetration conductor 52a which penetrates the dielectric layer 11; an auxiliary output coupling electrode 41b arranged on the inter-layer portion C of the laminate 10 to face the auxiliary resonance electrode 31b and connected to the output coupling electrode 40b of the output stage by a third penetration conductor 52b which penetrates the dielectric layer 11; an input terminal electrode 60a arranged on the top surface of the laminate 10 and connected to the auxiliary input coupling electrode 41a by a fourth penetration conductor 53a which penetrates the dielectric layer 11; and an output terminal electrode 60b arranged on the top surface of the laminate 10 and connected to the auxiliary output coupling electrode 41b by a fifth penetration conductor 53b which penetrates the dielectric layer 11.

The first ground electrode 21 is arranged on the entire surface of the bottom surface of the laminate 10, and the second ground electrode 22 is arranged on the nearly entire surface of the top surface of the laminate 10 except for the peripheries of the input terminal electrode 60a and the output terminal electrode 60b, so that the first ground electrode 21 and the second ground electrode 22 are connected to the ground potential, and therefore, the first ground electrode 21 and the second ground electrode 22 constitute a strip line resonator along with the resonance electrodes 30a, 30b, and 30c.

Since the strip-shaped resonance electrodes 30a, 30b, and 30c constitute a strip line resonator along with the first ground electrode 21 and the second ground electrode 22, and one end of each of the resonance electrodes 30a, 30b, and 30c is connected to the annular ground electrode 23, i.e., to the ground potential, the strip line resonator may function as a 1/4 wavelength resonator. The length of each of the resonance electrodes 30a, 30b, and 30c is adapted to be shorter than 1/4 of the wavelength at the center frequency of the bandpass filter by taking into consideration an capacitance effect that takes place between the auxiliary resonance electrodes 31a, 31b, and 31c and the annular ground electrode 23. For instance, the length of each of the resonance electrodes 30a, 30b, and 30c is set on the order of 2 to 6 mm when the relative dielectric constant of the dielectric layer 11 is set on the order of 10 by setting the center frequency as 4 GHz.

In addition, the resonance electrodes 30a, 30b, and 30c are arranged on the inter-layer portion A in parallel with each other to be edge-coupled with each other. As the interval between the resonance electrodes 30a, 30b, and 30c becomes narrower, the coupling may be stronger. However, if the interval becomes narrower, it may become difficult to manufacture the resonance electrodes 30a, 30b, and 30c. Accordingly, the interval between the resonance electrodes 30a, 30b, and 30c is set on the order of, for example, 0.05 to 0.5 mm. Besides, the resonance electrodes 30a, 30b, and 30c are arranged so that one end of each resonance electrode is alternate to the other end of its adjacent resonance electrode, that is, the resonance electrodes 30a, 30b, and 30c are coupled with each other in an inter-digital type, and this enables a coupling by magnetic fields to be added to a coupling by electric fields, thus making the coupling stronger compared to when the resonance electrodes 30a, 30b, and 30c are coupled with each other in a comb-line type. As such, since the resonance electrodes 30a, 30b, and 30c are not only edge-coupled but also coupled with each other in the inter-digital type, the frequency interval between resonance frequencies in each resonance mode is adapted to be appropriate to gain a broad passbandpassband width on the order of 40% by the relative bandwidth which is well in excess of the region that can be realized by the conventional filter using the 1/4 wavelength resonator and is very appropriate as a bandpass filter for UWB.

In addition, our review showed that it is not preferable to make a coupling between the resonance electrodes 30a, 30b, and 30c in an inter-digital type and make a broad-side coupling therebetween as well because the coupling becomes too strong to achieve the passbandpassband width of about 40% by the relative bandwidth.

The annular ground electrode 23 is formed on the inter-layer portion A of the laminate 10 in the shape of a ring to surround the peripheries of the resonance electrodes 30a, 30b, and 30c, and connected to one end of each of the resonance electrodes 30a, 30b, and 30c. The annular ground electrode 23 itself is connected to the ground potential, and therefore, the annular ground electrode 23 functions to connect one end of each of the resonance electrodes 30a, 30b, and 30c to the ground potential. The existence of the annular ground electrode 23 allows for easy connection of one end of each of the resonance electrodes 30a, 30b, and 30c arranged in the inter-digital type to the ground electrode even when the bandpass filter is formed at a portion of the module substrate. In addition, the annular ground electrode 23 annually surrounding the peripheries of the resonance electrodes 30a, 30b, and 30c, may reduce the leakage of electromagnetic waves generated from the resonance electrodes 30a, 30b, and 30c to the surroundings. This effect is particularly advantageous in preventing the other portions of the module substrate from being negatively affected when the bandpass filter is formed at a portion of the module substrate. Further, the length of the resonance electrodes 30a, 30b, and 30c may be shortened thanks to the capacitance generated between the annular ground electrode 23 and the auxiliary resonance electrodes 31a, 31b, and 31c, and this realizes a small size bandpass filter.

The strip-shaped input coupling electrode 40a is arranged on the inter-layer portion B different from the inter-layer portion A on which the resonance electrodes 30a, 30b, and 30c are arranged, so that its entirety is opposite to the resonance electrode 30a of the input stage, and therefore, the input coupling electrode 40a faces the resonance electrode 30a of the input stage over more than half of the length of the resonance electrode 30a of the input stage. Accordingly, the input coupling electrode 40a and the resonance electrode 30a of the input stage are broad-side coupled with each other, and therefore, the coupling becomes stronger than the edge-coupling. Further, the strip-shaped input coupling electrode 40a is connected to the auxiliary input coupling electrode 41a by the second penetration conductor 52a, and the contact point 71a of the input coupling electrode 40a and the second penetration conductor 52a is adapted to be located at an end of the input coupling electrode 40a, which is near the other end of the resonance electrode 30a of the input stage rather than the center of the input coupling electrode 40a in the longitudinal direction, and the other end of the input coupling electrode 40a is the open end. An electrical signal inputted from an external circuit is supplied to the input coupling electrode 40a through the contact point 71a. By doing so, the input coupling electrode 40a and the resonance electrode 30a of the input stage are coupled with each other in an inter-digital type, and therefore, a coupling by magnetic fields are added to a coupling by electric fields, so that the coupling becomes stronger than the comb-line type coupling alone or capacitive coupling alone. As such, since the input coupling electrode 40a is not only broad-side coupled but also coupled in an inter-digital type with the resonance electrode 30a of the input stage in its entirety, the input coupling electrode 40a ends up to be coupled with the resonance electrode 30a of the input stage very strongly.

Similarly, the strip-shaped input coupling electrode 40b is arranged on the inter-layer portion B different from the inter-layer portion A on which the resonance electrodes 30a, 30b, and 30c are arranged, so that its entirety is opposite to the resonance electrode 30b of the output stage, and therefore, the output coupling electrode 40b faces the resonance electrode 30b of the output stage over more than half of the length of the resonance electrode 30b of the output stage. Accordingly, the output coupling electrode 40b and the resonance electrode 30b of the output stage are broad-side coupled with each other, and therefore, the coupling becomes stronger than the edge-coupling. Further, the strip-shaped input coupling electrode 40b is connected to the auxiliary output coupling electrode 41b by the penetration conductor 52b, and the contact point 71b of the output coupling electrode 40b and the penetration conductor 52b is adapted to be located at an end of the output coupling electrode 40b, which is near the other end of the resonance electrode 30b of the output stage rather than the center of the output coupling electrode 40b in the longitudinal direction, and the other end of the output coupling electrode 40b is the open end. An electrical signal inputted from an external circuit is supplied to the output coupling electrode 40b through the contact point 71b. By doing so, the output coupling electrode 40b and the resonance electrode 30b of the output stage are coupled with each other in the inter-digital type, and therefore, a coupling by magnetic fields are added to a coupling by electric fields, so that the coupling becomes stronger than the comb line-type coupling alone or capacitive coupling alone. As such, since the output coupling electrode 40b is not only broad-side coupled but also coupled in an inter-digital type with the resonance electrode 30b of the output stage in its entirety, the output coupling electrode 40b ends up to be coupled with the resonance electrode 30b of the output stage very strongly.

As such, since the input coupling electrode 40a and the resonance electrode 30a of the input stage are coupled with each other very strongly and the output coupling electrode 40b and the resonance electrode 30b of the output stage are coupled with each other very strongly, a bandpass filter may be obtained, whose insertion loss is not greatly increased at frequencies located between resonance frequencies in each resonance mode even in the broad passbandpassband width well in excess of the region that may be achieved by the conventional filter using the 1/4 wavelength resonator, and which has a flat and low-loss transmission characteristicstransmission characteristic over the entire region of the broad pass bandpassband.

In addition, it is preferable that the shape dimensions of the input coupling electrode 40a and the output coupling electrode 40b are set to be substantially identical to those of the resonance electrode 30a and the resonance electrode 30b, respectively. As the interval between the input coupling electrode 40a and the resonance electrode 30a of the input stage and the interval between the output coupling electrode 40b and the resonance electrode 30b of the output stage are smaller, the coupling may become stronger, however, they become difficult to manufacture. Therefore, the intervals are set, for example, on the order of 0.01 to 0.5 mm.

The auxiliary resonance electrodes 31a, 31b, and 31c, respectively, are arranged on the inter-layer portion B of the laminate 10 to have an area facing the resonance electrodes 30a, 30b, and 30c, respectively, and an area facing the annular ground electrode 23. The area facing each of the resonance electrodes 30a, 30b, and 30c is connected to the other end of each of the resonance electrodes 30a, 30b, and 30c by each of the first penetration conductors 51a, 51b, and 51c that penetrate the dielectric layer 11 located between the auxiliary resonance electrodes 31a, 31b, and 31c and the resonance electrodes 30a, 30b, and 30c. In the area where the auxiliary resonance electrodes 31a, 31b, and 31c face the annular ground electrode 23, capacitance is generated between the auxiliary resonance electrodes 31a, 31b, and 31c and the annular ground electrode 23, and this may shorten the length of the resonance electrodes 30a, 30b, and 30c, thus enabling a small-size bandpass filter.

Further, each of the auxiliary resonance electrodes 31a, 31b, and 31c is connected to the other end of each of the resonance electrodes 30a, 30b, and 30c, and extended therefrom in the opposite direction of the one end of each of the resonance electrodes 30a, 30b, and 30c. Accordingly, an assembly of the resonance electrode 30a of the input stage and the auxiliary resonance electrode 31a connected to the resonance electrode 30a and an assembly of the input coupling electrode 40a and the auxiliary input coupling electrode 41a connected to the input coupling electrode 40a are generally broad-side coupled with each other and coupled in the inter-digital type as well, thus making the coupling very strong as described in detail later. Similarly, an assembly of the resonance electrode 30b of the output stage and the auxiliary resonance electrode 31b connected to the resonance electrode 30b and an assembly of the output coupling electrode 40b and the auxiliary output coupling electrode 41b connected to the input coupling electrode 40a are generally broad-sided coupled with each other and coupled in the inter-digital type as well, thus making the coupling very strong as described in detail later.

The area of the region of each of the auxiliary resonance electrodes 31a, 31b, and 31c facing the annular ground electrode 23 is set, for example, on the order of 0.01 to 3 mm² in terms of the necessary size and obtainable capacitance. As the interval between regions of the auxiliary resonance electrodes 31a, 31b, and 31c facing the annular ground electrode 23 is smaller, larger capacitance may be generated, however, they become difficult to manufacture. For example, the interval is set on the order of, for example, 0.01 to 0.5 mm.

The auxiliary input coupling electrode 41a is shaped as a strip, and arranged on the inter-layer portion C different from the inter-layer portion B on which the input coupling electrode 40a and the output coupling electrode 40b are arranged, to have a region facing the auxiliary resonance electrode 31a connected to the resonance electrode 30a of the input stage and a region facing the input coupling electrode 40a, and the region facing the input coupling electrode 40a is connected to the input coupling electrode 40a by the second penetration conductor 52a that penetrates the dielectric layer 11 located between the auxiliary input coupling electrode 41a and the input coupling electrode 40a. By doing so, the auxiliary input coupling electrode 41a connected to the input coupling electrode 40a and the auxiliary resonance electrode 31a connected to the resonance electrode 30a of the input stage are broad-side coupled and this coupling is added to the coupling between the input coupling electrode 40a and the resonance electrode 30a of the input stage, thus making the coupling stronger in entirety.

Besides, since the other end of the auxiliary input coupling electrode 41a, which is opposite to an end of the auxiliary input coupling electrode 41a connected to the second penetration conductor 52a, is connected to the input terminal electrode 60a that is arranged on the top surface of the laminate 10 by the fourth penetration conductor 53a, an assembly of the resonance electrode 30a of the input stage and the auxiliary resonance electrode 31a connected to the resonance electrode 30a and an assembly of the input coupling electrode 40a and the auxiliary input coupling electrode 41a connected to the input coupling electrode 40a are generally coupled with each other in the inter-digital type, and therefore, a coupling by magnetic fields and a coupling by electric fields are added to each other, thus making the coupling stronger. Accordingly, a stronger coupling may be achieved at the end of the auxiliary input coupling electrode 41a, which is connected to the input coupling electrode 40a, than at the other end of the auxiliary input coupling electrode 41a, which is connected to the input terminal electrode 60a.

The auxiliary output coupling electrode 41b is shaped as a strip, and arranged on the inter-layer portion C different from the inter-layer portion B on which the input coupling electrode 40a and the output coupling electrode 40b are arranged, to have a region facing the auxiliary resonance electrode 31b connected to the resonance electrode 30b of the output stage and a region facing the output coupling electrode 40b, and the region facing the output coupling electrode 40b is connected to the output coupling electrode 40b by the third penetration conductor 52b that penetrates the dielectric layer 11 located between the auxiliary output coupling electrode 41b and the output coupling electrode 40b. By doing so, the auxiliary output coupling electrode 41b connected to the output coupling electrode 40b and the auxiliary resonance electrode 31b connected to the resonance electrode 30b of the output stage are broad-side coupled with each other, and this coupling is added to the coupling between the output coupling electrode 40b and the resonance electrode 30b of the output stage, thus making the coupling stronger in entirety.

Besides, since the other end of the auxiliary output coupling electrode 41b, which is opposite to an end of the auxiliary output coupling electrode 4ba connected to the third penetration conductor 52b, is connected to the output terminal electrode 60b that is arranged on the top surface of the laminate 10 by the fifth penetration conductor 53b, an assembly of the resonance electrode 30b of the output stage and the auxiliary resonance electrode 31b connected to the resonance electrode 30b and an assembly of the output coupling electrode 40b and the auxiliary output coupling electrode 41b connected to the output coupling electrode 40b are generally coupled with each other in the inter-digital type, and therefore, a coupling by magnetic fields and a coupling by electric fields are added to each other, thus making the coupling stronger. Accordingly, a stronger coupling may be achieved at the end of the auxiliary output coupling electrode 41b, which is connected to the output coupling electrode 40b, than at the other end of the auxiliary output coupling electrode 41b, which is connected to the output terminal electrode 60b.

As such, since the assembly of the resonance electrode 30a of the input stage and the auxiliary resonance electrode 31a connected to the resonance electrode 30a and the assembly of the input coupling electrode 40a and the auxiliary input coupling electrode 41a connected to the input coupling electrode 40a are generally not only broad-side coupled but also coupled with each other in the inter-digital type, the coupling becomes very strong, and similarly, the assembly of the resonance electrode 30b of the output stage and the auxiliary resonance electrode 31b connected to the resonance electrode 30b and the assembly of the output coupling electrode 40b and the auxiliary output coupling electrode 41b connected to the output coupling electrode 40b are generally not only broad-side coupled but also coupled with each other in the inter-digital type, the coupling becomes very strong. Therefore, the increase of insertion loss at frequencies located between resonance frequencies in each resonance mode may be further decreased, and this realizes a bandpass filter having a flat and low-loss transmission characteristicstransmission characteristic over the entire region of the broad pass bandpassband.

In addition, the width of each of the auxiliary input coupling electrode 41a and the auxiliary output coupling electrode 41b is set, for example, to be substantially equal to that of each of the input coupling electrode 40a and the output coupling electrode 40b, and the length of each of the auxiliary input coupling electrode 41a and the auxiliary output coupling electrode 41b is set, for example, to be slightly longer than that of each of the auxiliary resonance electrode 31a and the auxiliary resonance electrode 31b. It might be preferable that the interval between the auxiliary input coupling electrode 41a and the auxiliary output coupling electrode 41b and the interval between the auxiliary resonance electrode 31a and the auxiliary resonance electrode 31b are narrower since the coupling becomes stronger as the interval becomes narrower, however, this may cause it difficult to manufacture them. For example, the interval is set, for example, on the order of 0.01 to 0.5 mm.

By doing so, a high-capacity bandpass filter may be achieved according to the first embodiment, which is very appropriate as a filter for UWB and has a flat and low-loss transmission characteristicstransmission characteristic over the entire region of the very broad pass bandpassband that corresponds to 40% by the relative bandwidth well in excess of the region that may be realized by the conventional filter using the 1/4 wavelength resonator.

### (Second Embodiment)

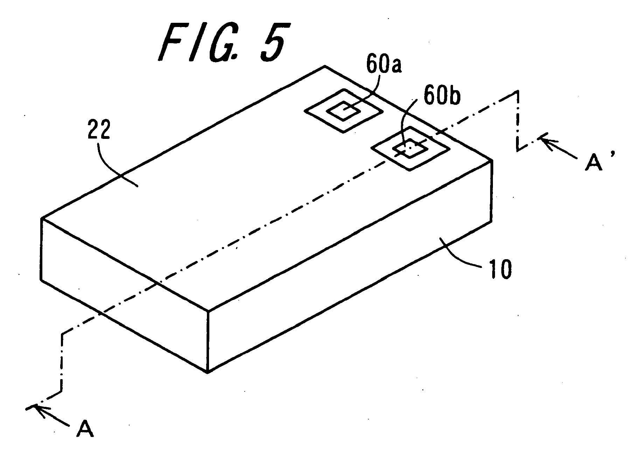

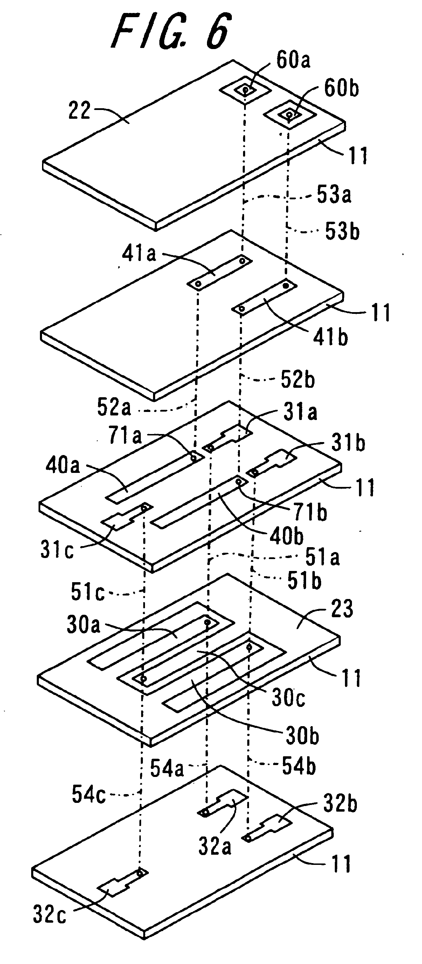

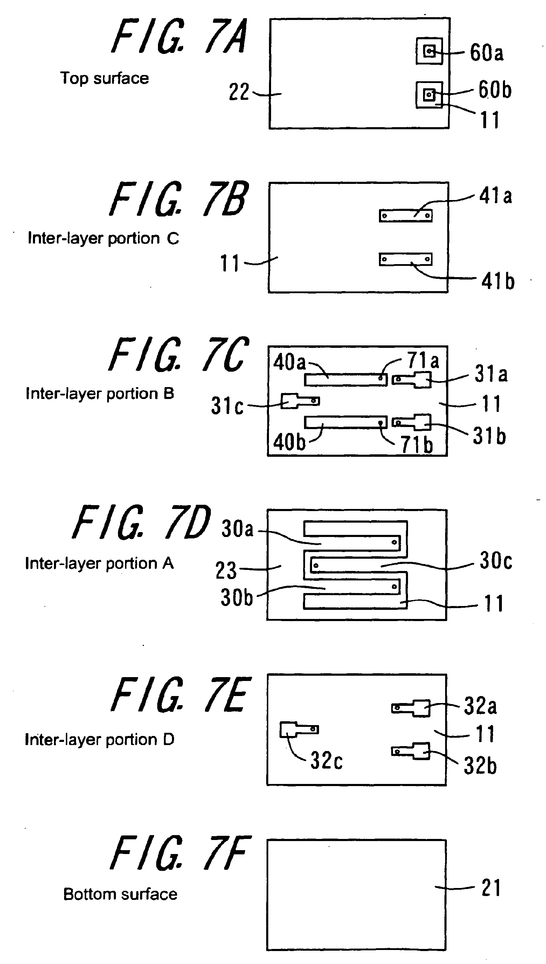

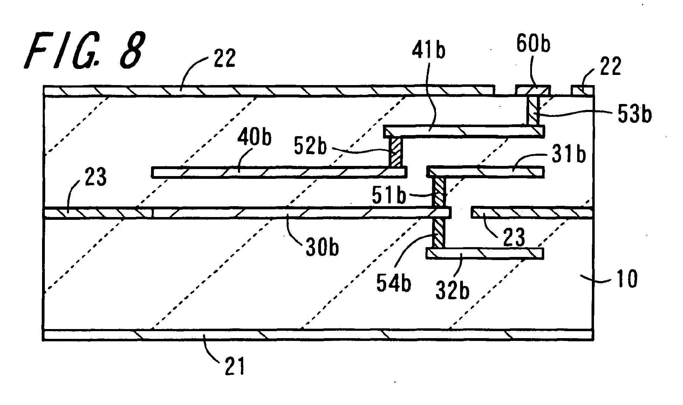

Fig. 5 is a perspective view schematically illustrating the external appearance of a bandpass filter according to a second embodiment of the present invention. Fig. 6 is an exploded perspective view schematically illustrating the bandpass filter shown in Fig. 5. Fig. 7A to Fig. 7F are plan views schematically illustrating the top and bottom surfaces and inter-layer portions of the bandpass filter shown in Fig. 5. Fig. 8 is a cross sectional view taken along the line A-A' of Fig. 5. Further, the following descriptions focus on only the differences from the first embodiments, wherein the same reference numerals refer to the same constitutional elements, and therefore, the repetitive descriptions will be omitted.

The bandpass filter according to the second embodiment has a characteristic of further including second auxiliary resonance electrodes 32a, 32b, and 32c. The second auxiliary resonance electrodes 32a, 32b, and 32c are arranged on the inter-layer portion D which is located at the opposite side of the inter-layer portion B on which the auxiliary resonance electrode 31a, 31b, and 31c are arranged with respect to the inter-layer portion A on which the resonance electrodes 30a, 30b, and 30c and the annular ground electrode 23 are arranged. The second auxiliary resonance electrodes 32a, 32b, and 32c, respectively, have regions facing the resonance electrodes 30a, 30b, and 30c, respectively, and a region facing the annular ground electrode 23, wherein the regions facing the resonance electrodes 30a, 30b, and 30c, respectively, are connected to the other ends of the resonance electrodes 30a, 30b, and 30c, respectively, by the sixth penetration conductors 54a, 54b, and 54c, respectively, that pass through the dielectric layer 11 located between the second auxiliary resonance electrodes 32a, 32b, and 32c and the resonance electrodes 30a, 30b, and 30c.

By doing so, the capacitance generated between the second auxiliary resonance electrodes 32a, 32b, and 32c and the annular ground electrode 23 is added to the capacitance generated between the auxiliary resonance electrodes 31a, 31b, and 31c and the annular ground electrode 23, and therefore, the capacitance between the open ends of the resonance electrodes 30a, 30b, and 30c and the ground potential is further increased, and this may further shorten the length of the resonance electrodes 30a, 30b, and 30c, thus enabling a smaller-size bandpass filter. Further, the planar shape of each of the auxiliary resonance electrode 31a, 31b, and 31c and each of the second auxiliary resonance electrode 32a, 32b, and 32c, may be made small in comparison with the bandpass filter according to the first embodiment of the present invention as described above in a case where there is no increase of the capacitance between the open end of each of the resonance electrode 30a, 30b, and 30c and the ground potential, and therefore, further size-decreased bandpass filter may be achieved. The area of the portion of each of the second auxiliary resonance electrodes 32a, 32b, and 32c facing the annular ground electrode 23 is set, for example, on the order of 0.01 to 3 mm² in consideration of a balance between the necessary size and obtainable capacitance. Larger capacitance may be generated as the interval between the portions of the second auxiliary resonance electrode 32a, 32b, and 32c facing the annular ground electrode 23 becomes narrower, however, this causes it difficult to manufacture them. For example, the interval is set, for example, on the order of 0.01 to 0.5 mm.

As such, a further size-reduced bandpass filter may be achieved in comparison with the bandpass filter according to the first embodiment of the present invention described above, according to the second embodiment.

### (Third Embodiment)

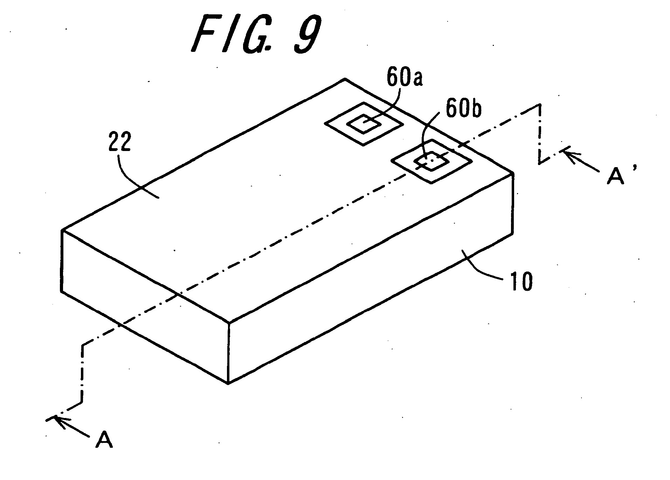

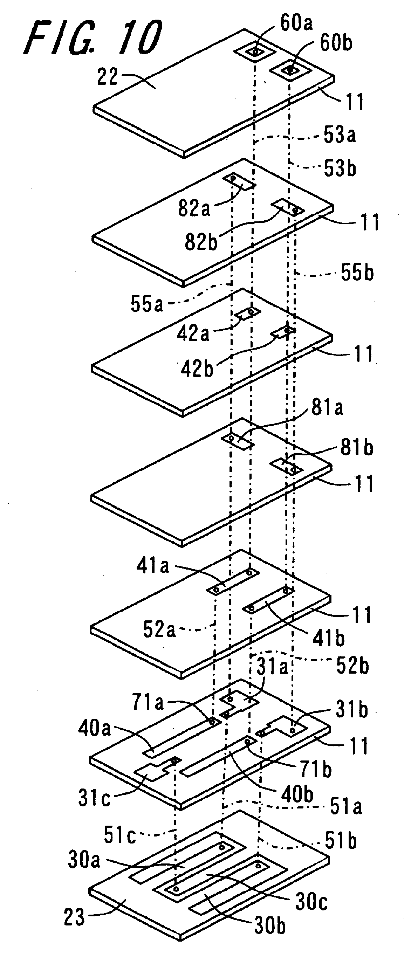

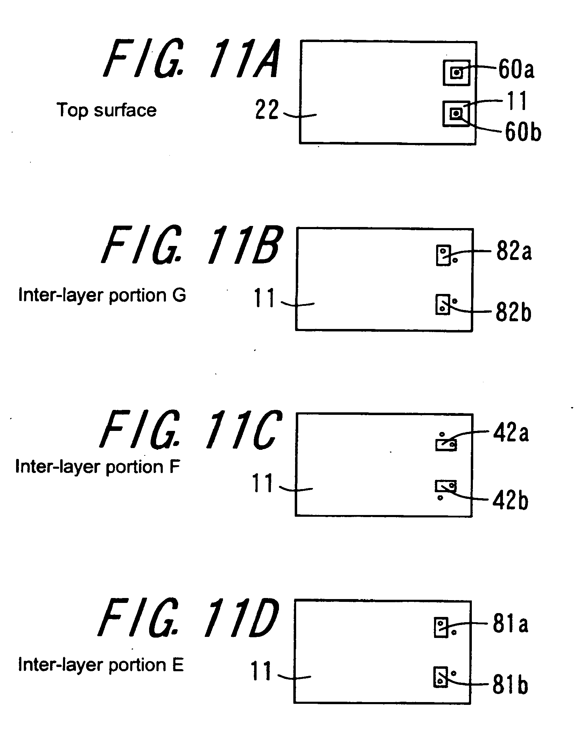

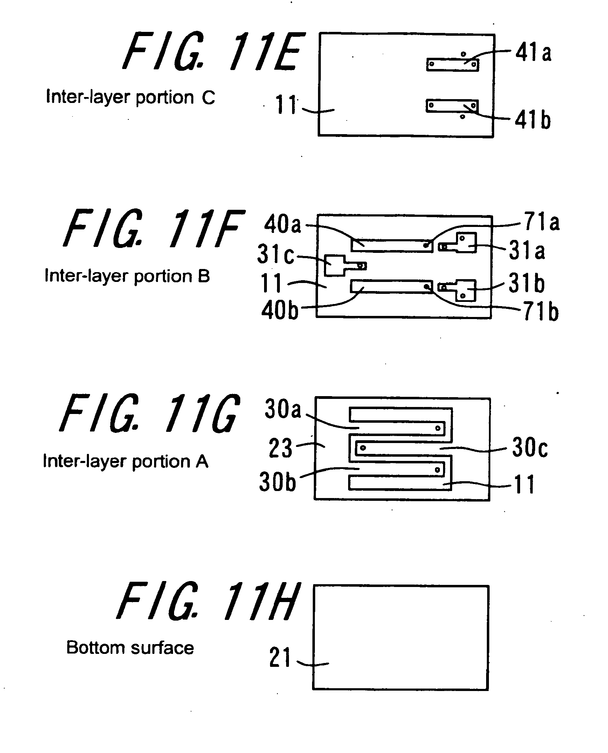

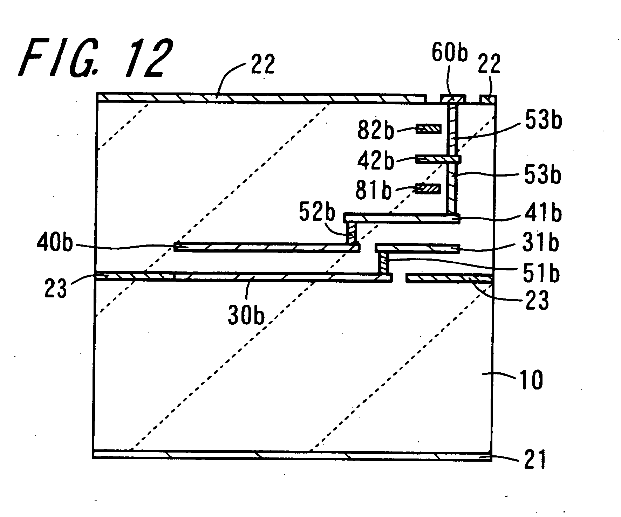

Fig. 9 is a perspective view schematically illustrating the external appearance of a bandpass filter according to a third embodiment of the present invention. Fig. 10 is an exploded perspective view schematically illustrating the bandpass filter shown in Fig. 9. Fig. 11A to Fig. 11H are plan views schematically illustrating the top and bottom surfaces and inter-layer portions of the bandpass filter shown in Fig. 9. Fig. 12 is a cross sectional view taken along the line A-A' of Fig. 9. Further, the following descriptions focus on only the differences from the first embodiments, wherein the same reference numerals refer to the same constitutional elements, and therefore, the repetitive descriptions will be omitted.

The bandpass filter according to the third embodiment has a characteristic in that a first input coupling reinforcement electrode 81a, a part of which faces the auxiliary input coupling electrode 41a, and a first output coupling reinforcement electrode 81b, a part of which faces the auxiliary output coupling electrode 41b, are arranged on the inter-layer portion E of the laminate 10 which is located at the opposite side of the inter-layer portion B on which the input coupling electrode 40a, the output coupling electrode 40b, and the auxiliary resonance electrode 31a, 31b, and 31c are arranged with respect to the inter-layer portion C on which the auxiliary input coupling electrode 41a and the auxiliary output coupling electrode 41b are arranged; a second auxiliary input coupling electrode 42a, a part of which faces the first input coupling reinforcement electrode 81a, and a second auxiliary output coupling electrode 42b, a part of which faces the first output coupling reinforcement electrode 81b, are arranged on the inter-layer portion F of the laminate 10 located at the opposite side of the inter-layer portion C on which the auxiliary input coupling electrode 41a and the auxiliary output coupling electrode 41b are arranged, with respect to the inter-layer portion E on which the first input coupling reinforcement electrode 81a and the first output coupling reinforcement electrode 81b are arranged; and a second input coupling reinforcement electrode 82a, a part of which faces the second auxiliary input coupling electrode 42a, and a second output coupling reinforcement electrode 82b, a part of which faces the second auxiliary output coupling electrode 42b, are arranged on the inter-layer portion G of the laminate 10 located at the opposite side of the inter-layer portion E on which the first input coupling reinforcement electrode 81a and the first output coupling reinforcement electrode 81b are arranged with respect to the inter-layer portion F on which the second auxiliary input coupling electrode 42a and the second auxiliary output coupling electrode 42b are arranged.

Further, the second auxiliary input coupling electrode 42a is connected to the fourth penetration conductor 53a that connects the auxiliary input coupling electrode 41a and the input terminal electrode 60a to each other, and the second auxiliary output coupling electrode 42b is connected to the fifth penetration conductor 53b that connects the auxiliary output coupling electrode 41b and the output terminal electrode 60b to each other. The first input coupling reinforcement electrode 81a and the second input coupling reinforcement electrode 82a are connected to the auxiliary resonance electrode 31a that is connected to the resonance electrode 30a of the input stage by the seventh penetration conductor 55a, and the first output coupling reinforcement electrode 81b and the second output coupling reinforcement electrode 82b are connected to the auxiliary resonance electrode 31b that is connected to the resonance electrode 30b of the output stage by the eighth penetration conductor 55b.

In the bandpass filter according to the third embodiment configured as above, the coupling of the first input coupling reinforcement electrode 81a and the second input coupling reinforcement electrode 82a, and the coupling of the auxiliary input coupling electrode 41a and the second auxiliary input coupling electrode 42a are added to the coupling of the input coupling electrode 40a and the auxiliary input coupling electrode 41a, and the coupling of the resonance electrode 30a of the input stage and the auxiliary resonance electrode 31a connected to the resonance electrode 30a, respectively, and this makes the coupling stronger. Similarly, the coupling of the first output coupling reinforcement electrode 81b and the second output coupling reinforcement electrode 82b, and coupling of the auxiliary output coupling electrode 41b and the second auxiliary output coupling electrode 42b are added to the coupling of the output coupling electrode 40b and the auxiliary output coupling electrode 41b, and the coupling of the resonance electrode 30b of the output stage and the auxiliary resonance electrode 31b connected to the resonance electrode 30b, respectively, and this makes the coupling stronger. By doing this, increase in insertion loss is further reduced at frequencies located between resonance frequencies in each resonance mode even in a very broad passbandpassband width, and therefore, a bandpass filter may be achieved, which has a flat and low-loss transmission characteristicstransmission characteristic over the entire region of the very broad pass bandpassband.

### (Fourth Embodiment)

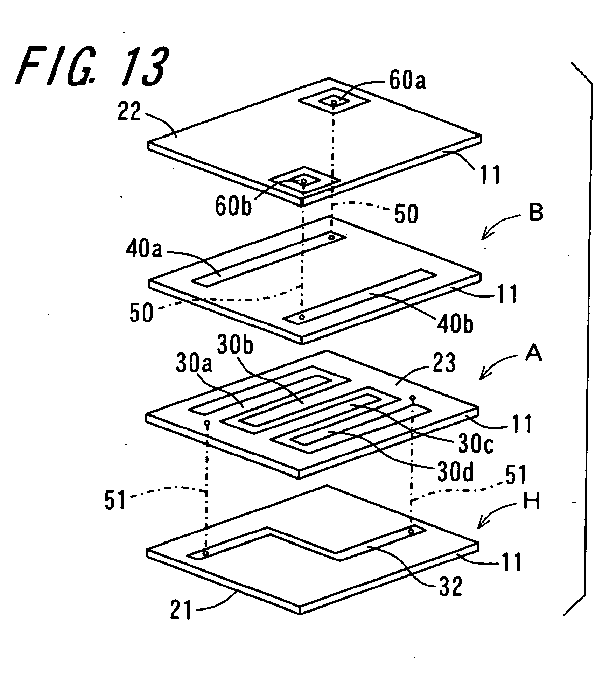

Fig. 13 is an exploded perspective view schematically illustrating a bandpass filter according to a fourth embodiment of the present invention. Here, the same reference numerals refer to the same constitutional elements, and therefore, the repetitive descriptions will be omitted.

The bandpass filter according to the fourth embodiment includes a laminate which is formed by stacking a plurality of dielectric layers 11; a first ground electrode 21 arranged on the bottom surface of the laminate; a second ground electrode 22 arranged on the top surface of the laminate; strip-shaped resonance electrodes 30a, 30b, and 30c (hereinafter, sometimes referred to as 'first resonance electrode') that are arranged on an inter-layer portion A of the laminate in parallel with each other; an annular ground electrode 23 shaped as a ring on the inter-layer portion A of the laminate to surround the peripheries of the resonance electrodes 30a, 30b, and 30c, wherein one end of each of the resonance electrodes 30a, 30b, and 30c is connected to the annular ground electrode 23; a strip-shaped input coupling electrode 40a arranged on an inter-layer portion B located over the inter-layer portion A of the laminate to face the resonance electrode 30a of the input stage; a strip-shaped output coupling electrode 40b arranged to face the resonance electrode 30d of the output stage; a resonance electrode coupling conductor 32 that is arranged on an inter-layer portion H located under the inter-layer portion A of the laminate and has a region facing each of the resonance electrodes so that one end and the other end thereof are connected to the annular ground electrode 23 through the first penetration conductor 51 and electromagnetically coupled with the resonance electrode 30a of the input stage and the resonance electrode 30d of the output stage in a nearly uniform manner; an input terminal electrode 60a arranged on the top surface of the laminate to be connected to the input coupling electrode 40a; and an output terminal electrode 60b connected to the output coupling electrode 40b.

Although not being shown, the first ground electrode 21 is arranged on the entire surface of the bottom surface of the laminate (the opposite surface of the surface of the dielectric layer 11 on which the resonance electrode coupling conductor 32 is arranged), and the second ground electrode 22 is arranged on the nearly entire surface of the surface of the laminate except for the peripheries of the input terminal electrode 60a and the output terminal electrode 60b, and therefore, the first ground electrode 21 and the second ground electrode 22 are connected to the ground potential, thus constituting a strip line resonator together with the resonance electrodes 30a, 30b, 30c, and 30d.

Since the strip-shaped resonance electrodes 30a, 30b, 30c, and 30d constitute a strip line resonator together with the first ground electrode 21 and the second ground electrode 22, and one end of each of the resonance electrode 30a, 30b, 30c, and 30d is connected to the annular ground electrode 23, thus to the ground potential, the strip line resonator functions as a 1/4 wavelength resonator.

Further, the resonance electrodes 30a, 30b, 30c, and 30d are arranged on the inter-layer portion A of the laminate in parallel with each other to be electromagnetically coupled (edge-coupled) with each other. As the interval between the resonance electrodes 30a, 30b, 30c, and 30d is smaller, a stronger coupling may be achieved, however, this causes it difficult to manufacture them. Therefore, the interval is set, for example, on the order of 0.05 to 0.5 mm. Besides, the resonance electrode 30a, 30b, 30c, and 30d are formed so that one end of each of the resonance electrodes is alternately arranged to the other end of its adjacent resonance electrode, i.e. arranged in an inter-digital type, and therefore, a coupling by electric fields and a coupling by magnetic fields are added to each other, and this makes the coupling stronger than when they are coupled in a comb-line form. As such, since the resonance electrodes 30a, 30b, 30c, and 30d are not only edge-coupled but also coupled with each other in the inter-digital type, the frequency interval between resonance frequencies in each resonance mode is adapted to be suitable for achieving a broad passbandpassband width on the order of 30% by the relative bandwidth which is well in excess of the region that could be achieved by the conventional filter using the 1/4 wavelength resonator and is very appropriate as a bandpass filter for UWB.

The inventor found that it is not preferable in achieving a passbandpassband width on the order of 30% by the relative bandwidth not only to broad-side couple but also to couple the resonance electrodes 30a, 30b, 30c, and 30d in the inter-digital type because the coupling becomes too strong.

Even though four resonance electrodes have been provided in the embodiment shown in Fig. 13, four or more resonance electrodes may be provided for the present invention and the number of the resonance electrodes does not matter as long as the losses are not increased. For example, six resonance electrodes may be provided for the present invention, which will be described later.

The annular ground electrode 23 is arranged in the shape of a ring on the inter-layer portion A of the laminate to surround the peripheries of the resonance electrodes 30a, 30b, 30c, and 30d, wherein the annular ground electrode 23 is connected to one end of each of the resonance electrodes 30a, 30b, 30c, and 30d. Since the annular ground electrode 23 itself is connected to the ground potential, the annular ground electrode 23 allows the one end of each of the resonance electrodes 30a, 30b, 30c, and 30d to be connected to the ground potential. The one end of each of the resonance electrodes 30a, 30b, 30c, and 30d is not directly connected to the first ground electrode 21 and the second ground electrode 22 with penetration conductors, but the one end of each of the resonance electrodes 30a, 30b, 30c, and 30d arranged in the inter-digital type may be easily connected to the ground potential by the annular ground electrode 23 even though the bandpass filter is formed at a portion in the module substrate. Further, the annular ground electrode 23 surrounds the peripheries of the resonance electrodes 30a, 30b, 30c, and 30d, and this may reduce leakage of electromagnetic waves emitted from the resonance electrodes 30a, 30b, 30c, and 30d to the surroundings. This effect is particularly advantageous in preventing the other portions of the module substrate from being negatively affected in a case where the bandpass filter is formed in a portion of the module substrate.

The strip-shaped input coupling electrode 40a is arranged on the inter-layer portion B different from the inter-layer portion A on which the resonance electrodes 30a, 30b, 30c, and 30d are arranged (the inter-layer portion located above the inter-layer portion A on which the resonance electrodes 30a, 30b, 30c, and 30d are arranged) so that its entirety faces the resonance electrode 30a of the input stage, and therefore, is adapted to face the resonance electrode 30a of the input stage over more than half of the length of the resonance electrode 30a of the input stage. Accordingly, the input coupling electrode 40a and the resonance electrode 30a of the input stage are broad-side coupled with each other, and this makes the coupling stronger compared to when they are edge-coupled. Further, the contact point of the strip-shaped input coupling electrode 40a and the penetration conductor 50 is located at an end of the input coupling electrode 40a, which is near the other end of the resonance electrode 30a of the input stage rather than the center of the input coupling electrode 40a in the longitudinal direction, and therefore, and the other end of the input coupling electrode 40a is the open end. An electrical signal inputted from an external circuit is supplied through the contact point to the input coupling electrode 40a. By doing so, the input coupling electrode 40a and the resonance electrode 30a are coupled with each other in the inter-digital type, and therefore, a coupling by magnetic fields and a coupling by electric fields are added to each other, and this makes the coupling stronger than when they are coupled in the comb-line type alone or capacitively coupled alone. As such, since the input coupling electrode 40a is broad-side coupled in its entirety with the resonance electrode 30a of the input stage, and coupled in the inter-digital type as well, the input coupling electrode 40a becomes coupled with the resonance electrode 30a of the input stage very strongly. Further, this principle is also true for output.

As such, since the input coupling electrode 40a and the resonance electrode 30a of the input stage are coupled with each other very strongly and the output coupling electrode 40b and the resonance electrode 30b of the output stage are coupled with each other very strongly, a bandpass filter may be obtained, whose insertion loss is not greatly increased at frequencies located between resonance frequencies in each resonance mode even in the broad passbandpassband width well in excess of the region that may be achieved by the conventional filter using the 1/4 wavelength resonator, and which has a flat and low-loss transmission characteristicstransmission characteristic over the entire region of the broad pass bandpassband.

The resonance electrode coupling conductor 32 is arranged on the inter-layer portion H different from the inter-layer portion A on which the resonance electrodes 30a, 30b, 30c, and 30d are arranged (the inter-layer portion located under the inter-layer portion A on which the resonance electrodes 30a, 30b, 30c, and 30d are arranged). One end of the resonance electrode coupling conductor 32 is connected to the ground potential (annular ground electrode 23) near one end of the resonance electrode 30a of the input stage through the first penetration conductor 51, and the other end of the resonance electrode coupling conductor 32 is connected to the ground potential (annular ground electrode 23) near one end of the resonance electrode 30d of the output stage through the first penetration conductor 51, and therefore, the resonance electrode coupling conductor 32 has a region facing each resonance electrode to be electromagnetically coupled with the resonance electrode 30a of the input stage and the resonance electrode 30d of the output stage in a nearly uniform manner.

In the embodiment shown in Fig. 13, the resonance electrode coupling conductor 32 includes an input stage coupling region that faces the resonance electrode 30a of the input stage, an output stage coupling region that faces the resonance electrode 30d of the output stage, and a connection region that connects the input stage coupling region and the output stage coupling region perpendicularly to the input stage coupling region and the output stage coupling region. That is, the resonance electrode coupling conductor 32 is formed in a so-called "crank structure". In this structure, one portion which is near one end (short end) of the resonance electrode 30a of the input stage and one portion which is near one end (short end) of the resonance electrode 30d of the output stage are adapted to be coupled with each other. Here, the resonance electrode coupling conductor 32 is preferably formed to be point-symmetrical with respect to a point which is far away at the same distance from one end and the other end of the resonance electrode coupling conductor 32 from the point of view of filter design, and particularly, the shape shown in Fig. 13 is most preferred, however, any shapes may be available as long as they are adapted to be point-symmetrical.

In the resonance electrode coupling conductor 32 whose one end is connected to the annular ground electrode 23 near the one end (short end) of the resonance electrode 30a of the input stage and the other end is connected to the annular ground electrode 23 near the one end (short end) of the resonance electrode 30d of the output stage, a portion near one end (short end) of the resonance electrode 30a of the input stage and a portion near one end (short end) of the resonance electrode 30d of the output stage are coupled with each other, so that the resonance electrode of the input stage and the resonance electrode of the output stage end up to be inductively coupled with each other. In the meanwhile, a capacitive coupling is achieved between the resonance electrodes, which are neighbored to each other (between 30a and 30b, between 30b and 30c, and between 30c and 30d). This structure constitutes a so-called elliptic function filter. Accordingly, it can be possible to form one attenuation pole at the lower band side and one attenuation pole at the higher band side than the pass bandpassband. By doing so, there may be achieved a filter characteristic of being abruptly attenuated at the bands other than the pass bandpassband.

In addition, a four-stage resonator, as an example of the elliptic function filter, may form attenuation poles at the lower band side and the higher band side than the pass bandpassband as long as the four-stage resonator has the following relationship: the coupling between the first-stage resonator and the second-stage resonator is positive (+), the coupling between the second-stage resonator and the third-stage resonator is positive (+), the coupling between the third-stage resonator and the fourth-stage resonator is positive(+), and the coupling between the first-stage resonator and the fourth-stage resonator is negative(-).

By doing so, a high-capacity bandpass filter may be achieved according to the fourth embodiment, which has a flat and low-loss transmission characteristicstransmission characteristic over the entire region of the very broad pass bandpassband which reaches 30% by the relative bandwidth that is well in excess of the region that may be realized by the conventional filter using the conventional 1/4 wavelength resonator, has attenuation poles at the lower band side and higher band side than the pass bandpassband is very appropriate as a filter for UWB.

### (Fifth Embodiment)

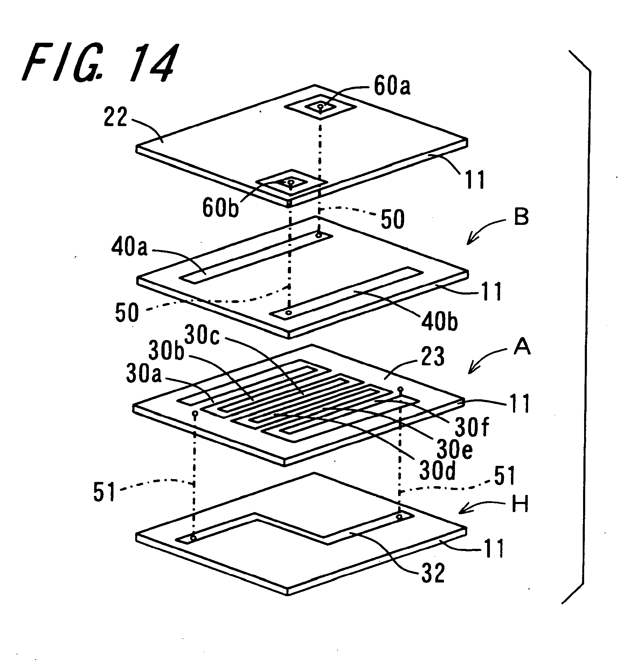

Fig. 14 is an exploded perspective view schematically illustrating a bandpass filter according to a sixth embodiment of the present invention. The only difference in the structure from the fourth embodiment is that the resonance electrode is configured to have six stages, such as the resonance electrodes 30a, 30b, 30c, 30d, 30e, and 30f.

Even in the bandpass filter according to the fifth embodiment, there is the resonance electrode coupling conductor 32 whose one end is connected to the annular ground electrode 23 near one end (short end) of the resonance electrode 30a of the input stage through the first penetration conductor 51 and the other end is connected to the annular ground electrode 23 near one end (short end) of the resonance electrode 30d of the output stage through the first penetration conductor 51. Therefore, the resonance electrode coupling conductor 32 is adapted to be inductively coupled with the resonance electrode of the input stage and the resonance electrode of the output stage at a portion near one end (short end) of the resonance electrode 30a of the input stage and at a portion near one end of (short end) of the resonance electrode 30d of the output stage. In the meanwhile, a capacitive coupling is made between two adjacent resonance electrodes (between 30a and 30b, between 30b and 30c, between 30c and 30d, between 30d and 30e, and between 30e and 30f). This structure constitutes a so-called pseudo elliptic function filter. Accordingly, an attenuation pole may be formed at the lower band side and an attenuation pole at the higher band side than the pass bandpassband. By doing so, there may be achieved a filter characteristic of being abruptly attenuated at the other bands than the pass bandpassband.

In addition, the pseudo elliptic function filter, for example, a six-stage resonator, may form attenuation poles at the lower band side and the higher band side than the pass bandpassband as long as it has the following relationship: the coupling between the first-stage resonator and the second-stage resonator is positive (+), the coupling between the second-stage resonator and the third-stage resonator is positive (+), the coupling between the third-resonator and the fourth-resonator is positive (+), the coupling between the fourth-stage resonator and the fifth-stage resonator is positive (+), the coupling between the fifth-stage resonator and the sixth-stage resonator is positive (+), and the coupling between the first-stage resonator and the sixth-stage resonator is negative (-). Here, "positive" corresponds to being capacitive and "negative" corresponds to being inductive.

As such, there may be achieved a bandpass filter according to the fifth embodiment, which has an attenuation characteristic of being more abruptly attenuated than the bandpass filter according to the fourth embodiment of the present invention described above.

### (Sixth Embodiment)

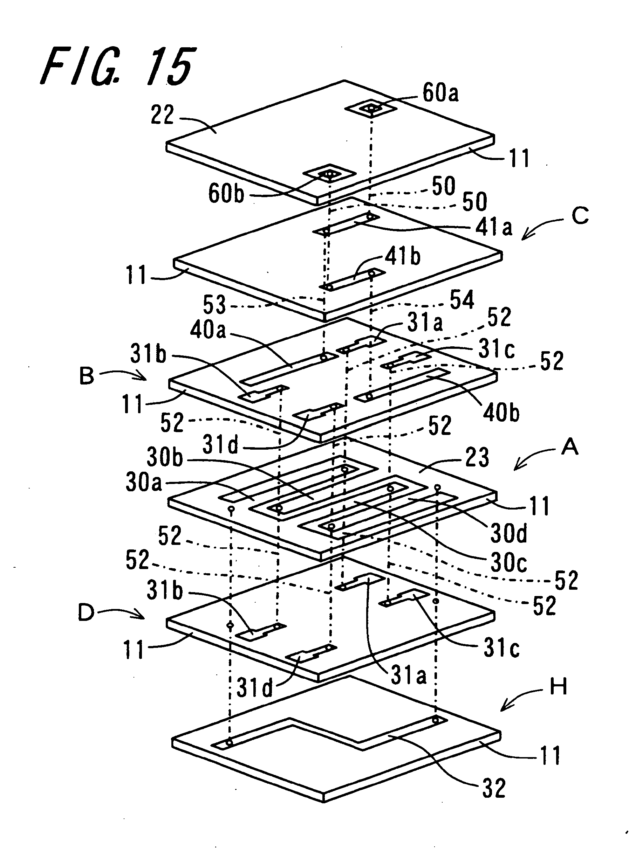

Fig. 15 is an exploded perspective view schematically illustrating a bandpass filter according to a sixth embodiment of the present invention. The difference in structure from the fourth embodiment shown in Fig. 13 is that the auxiliary resonance electrodes 31a, 31b, 31c, and 31d are arranged on the inter-layer portion B located above the inter-layer portion A on which the resonance electrodes 30a, 30b, 30c, and 30d and the annular ground electrode 23 are arranged, each having a region facing the annular ground electrode 23 and a region facing each of the resonance electrodes 30a, 30b, 30c, and 30d, and the auxiliary resonance electrodes 31a, 31b, 31c, and 31d are arranged on the inter-layer portion D located under the inter-layer portion A on which the resonance electrodes 30a, 30b, 30c, and 30d and the annular ground electrode 23 are arranged, each having a region facing the annular ground electrode 23 and a region facing each of the resonance electrodes 30a, 30b, 30c, and 30d. The resonance electrodes 30a, 30b, 30c, and 30d and the auxiliary resonance electrodes 31a, 31b, 31c, and 31d are connected to each other through the second penetration conductors 52 that penetrate the dielectric layer 11. By doing so, the capacitance between the auxiliary resonance electrodes 31a, 31b, 31c, and 31d and the annular ground electrode 23 is added, and therefore, the capacitance between the other ends (open ends) of the resonance electrodes 30a, 30b, 30c, and 30d and the ground potential is further increased, and therefore, the length of the resonance electrodes 30a, 30b, and 30c may be shortened, thus enabling a smaller-size bandpass filter.

In addition, in the sixth embodiment shown in Fig. 15, each of the auxiliary resonance electrodes 31a, 31b, 31c, and 31d is provided in pair: one at the upper side and one at the lower side. In a case where the it does not matter if the length is less shortened than the above embodiment, however, the auxiliary resonance electrodes 31a, 31b, 31c, and 31d may be configured to be provided either above or under the inter-layer portion A on which the resonance electrodes 30a, 30b, 30c, and 30d and the annular ground electrode 23 are arranged.

Further, in addition to the formation of the auxiliary resonance electrode 31a and 31d, the auxiliary input coupling electrode 41a and the auxiliary output coupling electrode 41b are formed to correspond to the input coupling electrode 40a and the output coupling electrode 40b, respectively, on the inter-layer portion C different from the inter-layer portion A on which the resonance electrodes 30a, 30b, 30c, and 30d and the annular ground electrode 23 are arranged and the inter-layer portions B and D on which the auxiliary resonance electrodes 31a, 31b, 31c,and 31d are arranged.

As such, there may be achieved a bandpass filter according to the sixth embodiment, whose size is further reduced compared to the bandpass filter according to the fourth embodiment of the present invention.

Further, the auxiliary input coupling electrode 41a shown in Fig. 15 is shaped as a strip and arranged to have a region facing the auxiliary resonance electrode 31a and a region facing the input coupling electrode 40a, and the region facing the input coupling electrode 40a is connected to the input coupling electrode 40a through the third penetration conductor 53 that penetrates the dielectric layer 11 located between the auxiliary input coupling electrode 41a and the input coupling electrode 40a. By doing so, the auxiliary input coupling electrode 41a and the auxiliary resonance electrode 31a are broad-side coupled with each other, and this coupling is added to a coupling between the input coupling electrode 40a and the resonance electrode 30a of the input stage, thus making the overall coupling stronger.

Similarly, the auxiliary output coupling electrode 41b is shaped as a strip, and arranged to have a region facing the auxiliary resonance electrode 31d and a region facing the output coupling electrode 40b, and the region facing the output coupling electrode 40b is connected to the output coupling electrode 40b through the fourth penetration conductor 54 that penetrates the dielectric layer 11 located between the auxiliary output coupling electrode 41b and the output coupling electrode 40b. By doing so, the auxiliary output coupling electrode 41b and the auxiliary resonance electrode 31d are broad-side coupled with each other, and this coupling is added to a coupling between the output coupling electrode 40b and the resonance electrode 30d of the output stage, thus making the overall coupling stronger.

As such, an assembly of the resonance electrode 30a of the input stage and the auxiliary resonance electrode 31a connected to the resonance electrode 30a and an assembly of the input coupling electrode 40a and the auxiliary input coupling electrode 41a connected to the input coupling electrode 40a are coupled with each other in the inter-digital type, thus making the two assemblies coupled with each other very strongly, and similarly, an assembly of the resonance electrode 30b of the output stage and the auxiliary resonance electrode 31b connected to the resonance electrode 30b and an assembly of the output coupling electrode 40b and the auxiliary output coupling electrode 41b connected to the output coupling electrode 40b are generally not only broad-side coupled but also coupled with each other in the inter-digital type, thus making the two assemblies coupled with each other very strongly, and therefore, increase of insertion loss is further reduced at frequencies between resonance frequencies in each resonance mode , and this realizes a bandpass filter having a flat and low-loss transmission characteristicstransmission characteristic over the entire region of the broad pass bandpassband.

### (Seventh Embodiment)

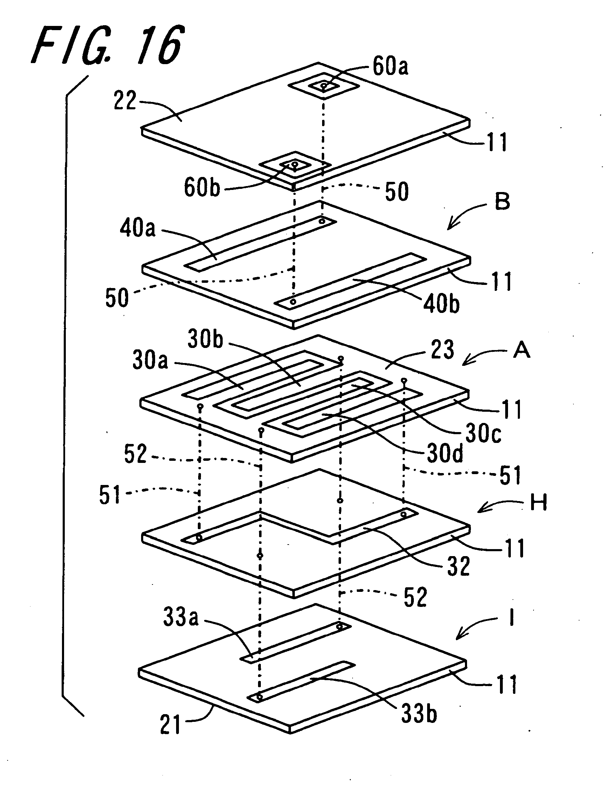

Fig. 16 is an exploded perspective view schematically illustrating a bandpass filter according to a seventh embodiment of the present invention. In this embodiment, the same reference numerals refer to the same constitutional elements, and therefore, the repetitive descriptions will be omitted. The bandpass filter according to the seventh embodiment is similar to the bandpass filter according to the embodiment of Fig. 13, however, it should be noted that the second resonance electrodes 33a and 33b are formed on the inter-layer portion I which is located further under the inter-layer portion H on which the resonance electrode coupling conductor 32 is arranged.

The bandpass filter according to the seventh embodiment includes an laminate formed by stacking a plurality of dielectric layers 11; a first ground electrode 21 arranged on the bottom surface of the laminate; a second ground electrode 22 arranged on the top surface of the laminate; strip-shaped first resonance electrodes 30a, 30b, 30c, and 30d arranged on an inter-layer portion A of the laminate in parallel with each other; an annular ground electrode 23 shaped as a ring to surround the peripheries of the resonance electrodes 30a, 30b, 30c, and 30d on the inter-layer portion A of the laminate, wherein one end of each of the resonance electrodes 30a, 30b, 30c, and 30d is connected to the annular ground electrode 23; a strip-shaped input coupling electrode 40a arranged on an inter-layer portion B located over the inter-layer portion A of the laminate to face the resonance electrode 30a of the input stage; a strip-shaped output coupling electrode 40b arranged to face the resonance electrode 30d of the output stage; a resonance electrode coupling conductor 32 arranged on an inter-layer portion H located under the inter-layer portion A of the laminate and having a region facing each resonance electrode so that one end and the other end of the resonance electrode coupling conductor 32 are connected to the annular ground electrode 23 through first penetration conductors 51 and electromagnetically coupled with the resonance electrode 30a of the input stage and the resonance electrode 30d of the output stage in a nearly uniform manner; second resonance electrodes 33a and 33b arranged on an inter-layer portion I which is located further under the inter-layer portion H on which the resonance electrode coupling conductor 32 is arranged to be parallel with the first resonance electrodes 30a, 30b, 30c, and 30d, wherein one end of each of the second resonance electrodes 33a and 33b is connected to the ground potential through the second penetration conductor, wherein the second resonance electrodes 33a and the second resonance electrode 33b are different in length from the resonance electrodes 30a, 30b, 30c, and 30d; an input terminal electrode 60a arranged on the top surface of the laminate to be connected to the input coupling electrode 40a; and an output terminal electrode 60b connected to the output coupling electrode 40b.

Although being not shown, the first ground electrode 21 is arranged on the entire surface of the bottom surface of the laminate (which is the opposite surface of the surface on which the second resonance electrodes 33a and 33b are arranged) and the second ground electrode 22 is arranged on the nearly entire surface of the top surface of the laminate, except for the peripheries of the input terminal electrode 60a and the output terminal electrode 60b, and therefore, either one of the first ground electrode 21 or the second ground electrode 22 may be connected to the ground potential, thus constituting a strip line resonator together with the resonance electrodes 30a, 30b, 30c, and 30d.

Even though four first resonance electrodes are provided in the embodiment shown in Fig. 16, four or more first resonance electrodes may be provided for the present invention and the number of the first resonance electrodes does not matter as long as the first resonance electrodes are provided in such an extent not to increase the loss. For example, six first resonance electrodes may be provided as described later.

The strip-shaped second resonance electrodes 33a and 33b are arranged in parallel with the first resonance electrodes 30a, 30b, 30c, and 30d on the inter-layer portion I which is located under the inter-layer portion H on which the resonance electrode coupling conductor 32 is arranged, to have the different length from that of the resonance electrodes 30a, 30b, 30c, and 30d (shorter than the length of the first resonance electrodes 30a, 30b 30c, and 30d in the Embodiment). Further, one end of each of the second resonance electrode 33a and 33b is connected to the ground potential (annular ground electrode 23) through the second penetration conductor 52. Specifically, the second resonance electrode 33a is connected near one end of the first resonance electrode 30b through the second penetration conductor 52 and the second resonance electrode 33b is connected near one end of the first resonance electrode 30c through the second penetration conductor 52. This structure causes the resonance frequency to be located near the cut-off frequency at the outside of the pass bandpassband therefore, may function as a so-called counteraction resonator (notch filter). In addition, the expression "near the cut-off frequency at the outside of the pass bandpassband" refers to a band between an attenuation pole formed by the resonance electrode coupling conductor 32 and the cutoff frequency, wherein the term "attenuation pole formed by the resonance electrode coupling conductor 32" refers to an attenuation pole formed at the lower band side or higher band side than the pass bandpassband in the construction where the second resonance electrode 33a and 33b are not arranged.

Here, one or more second resonance electrode may be provided and the number thereof does not matter as long as the second resonance electrode is provided in such an extent not to increase the loss of the filter. However, in view of a fact that it allows filter design to be easily done to form the filter in point symmetry with respect to the center of the filter formation region similarly to a general filter that is formed to have an symmetrical equivalent circuit, the second resonance electrode is preferably arranged in point symmetry with respect to the filter region surrounded by the annular ground electrode 23. Therefore, the bandpass filter of the present invention has the first resonance electrode in even numbers (four in this Embodiment) and the second resonance electrode in even numbers (two in this Embodiment) as shown in Fig. 16, and therefore, is preferably formed in point symmetry as seen from the above, with respect to the intersection point of a line connecting one end of the resonance electrode 30a of the input stage and one end of the resonance electrode 30d of the output stage and a line connecting the other end of the resonance electrode 30a of the input stage and the other end of the resonance electrode 30d of the output stage.

Further, even though the second resonance electrodes 33a and 33b are formed to be shorter than the resonance electrodes 30a, 30b, 30c, and 30d in the embodiment, the length is determined according to whether the attenuation pole is formed at lower band side or higher band side than the pass bandpassband. That is, in a case where the attenuation pole is formed at lower band side than the pass bandpassband, the second resonance electrode 33a and 33b are formed longer than the resonance electrodes 30a, 30b, 30c, and 30d, and in a case where the attenuation pole is formed at higher band side than the pass bandpassband, the second resonance electrode 33a and 33b are formed shorter than the resonance electrodes 30a, 30b, 30c, and 30d. In this embodiment, the second resonance electrodes 33a and 33b are formed shorter than the resonance electrodes 30a, 30b, 30c, and 30d since the attenuation pole is formed at higher band side than the pass bandpassband.

Further, even though the inter-layer portion I on which the second resonance electrode 33a and 33b are arranged is located under the inter-layer portion H on which the resonance electrode coupling conductor 32 is arranged, the arrangement may be made vice versa.

As such, the construction which has the strip-shaped second resonance electrodes 33a and 33b may provide a further abrupt attenuation characteristic compared to the construction without the second resonance electrodes 33a and 33b.

Here, it is necessary to consider the amount of coupling between the second resonance electrodes and the first resonance electrodes upon preparation of the second resonance electrodes. Specifically, in a case where the second resonance electrodes is longer than the first resonance electrode, the ratio of the length (area) of the region of the second resonance electrode overlapping the first resonance electrode with respect to the entire region of the second resonance electrode in the longitudinal direction of the second resonance electrode is small, and therefore, the second resonance electrodes is preferably arranged to be adjacent to the first resonance electrode that has an inter-digital relationship with the second resonance electrode as seen from the above (the portion which is connected to the ground potential is opposite between the first resonance electrode and the second resonance electrode) to earn the amount of coupling, and preferably arranged to face the first resonance electrode that has an inter-digital relationship with the second resonance electrode if it is desired that the second resonance electrode is best coupled with the first resonance electrode. In the meanwhile, in a case where the second resonance electrode is shorter than the first resonance electrode, the second resonance electrode overlaps the first resonance electrode in its entirety in the longitudinal direction, and therefore, it is preferable that the second resonance electrode is arranged to be adjacent to the first resonance electrode that has a comb-line relationship as seen from the above (the portion which is connected to the ground potential is the same between the first resonance electrode and the second resonance electrode) to reduce the amount of coupling, and it is particularly preferable that the second resonance electrode is arranged to be close to the first resonance electrode that has a comb-line relationship as seen from the above in such an extent that the entire region of the second resonance electrode does not face the first resonance electrode. In addition, the adjustment of the amount of coupling is dependent on the thickness of a dielectric layer arranged between the first resonance electrode and the second resonance electrode, the width of each resonance electrode, the area of a facing portion, and the like. Accordingly, it is preferable to arrange the second resonance electrode at the location which may acquire the desired amount of coupling by taking these into consideration.

In the embodiment, the second resonance electrode 33a is arranged to be partially opposite to the first resonance electrode 30b as seen from the above, and the second resonance electrode 33b is arranged to be partially opposite to the first resonance electrode 30c as seen from the above.

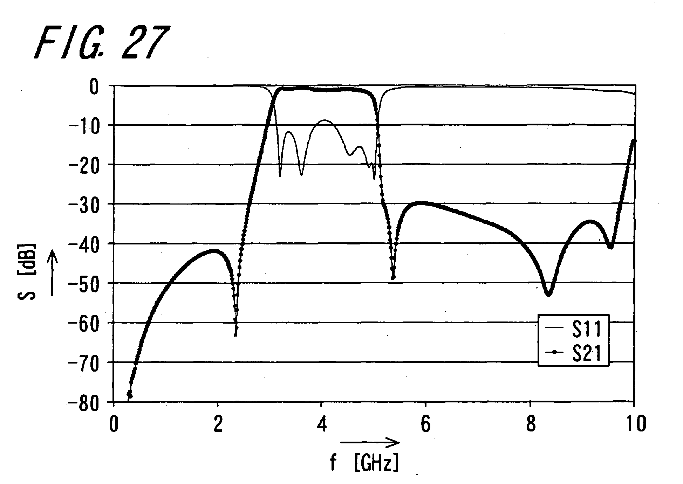

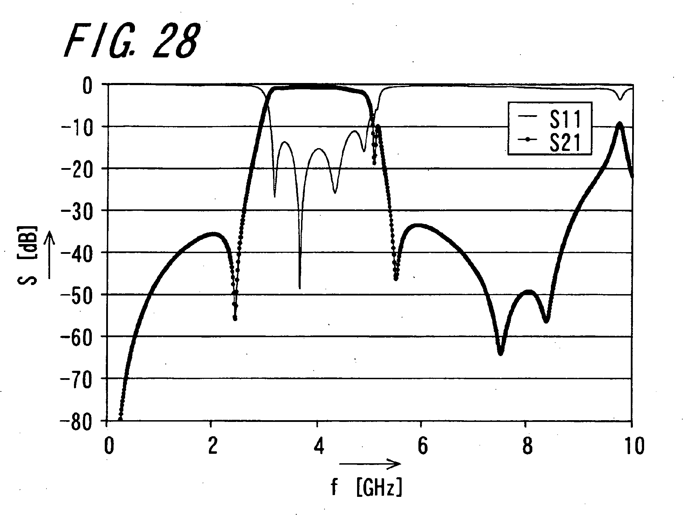

Hereinafter, it will be described to improve the attenuation characteristic by adjusting the amount of coupling of the second resonance electrode. For example, in a case where the desired amount of coupling is not obtained as shown in Fig. 28, an abrupt attenuation characteristic may be obtained at bands fairly near the cutoff frequency outside the appropriate pass bandpassband, however, a sharp rising occurs at the high band side of the attenuation pole (between attenuation poles) by the second resonance electrode. In contrast, in a case where a desired amount of coupling is obtained as shown in Fig. 27, it can be seen that such sharp rising as shown in Fig. 28 does not occur and an abrupt attenuation characteristic may be obtained without the sharp rising.

By doing so, there may be achieve a high-capacity bandpass filter according to the embodiment, which has a flat and low-loss transmission characteristicstransmission characteristic over the entire region of the very broad pass bandpassband that reaches 30% by the relative bandwidth well in excess of the region that may be realized by the conventional filter using the 1/4 wavelength resonator, has the attenuation poles at the lower band side and the higher band side than the pass bandpassband is fairy appropriate as a filter for UWB.

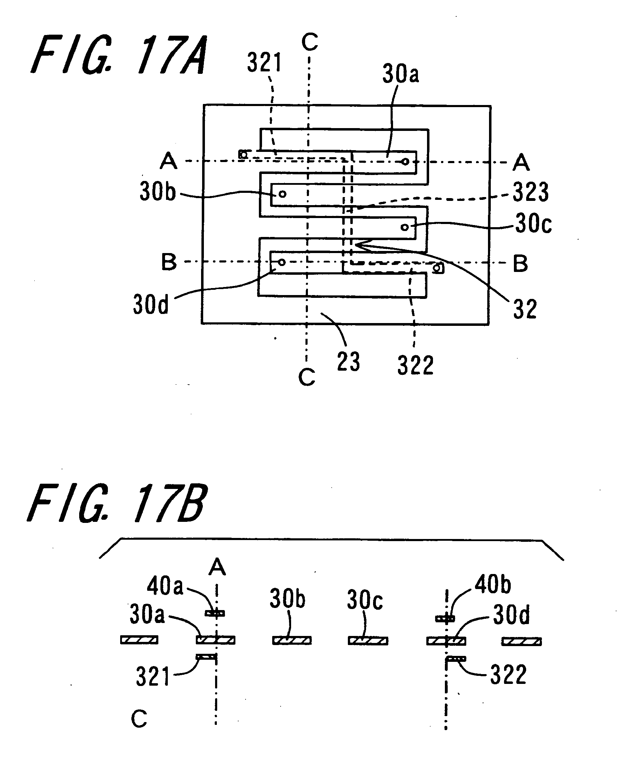

Further, Fig. 17A is a view schematically illustrating the resonance electrode coupling conductor 32 and the resonance electrodes 30a, 30b, 03c, and 03d, shown in Fig. 16, which are seen from the above, and Fig. 17B is a view schematically illustrating the resonance electrode coupling conductor 32, the resonance electrodes 30a, 30b, 30c, and 30d, the input coupling electrode 40a, and the output coupling electrode 40b shown in Fig. 16, which is seen from their cross section. As shown in Fig. 17A and Fig. 17B, it is preferable in the resonance electrode coupling conductor 32 that an input stage coupling region 321 is shaped as a strip and the central axis line extending in the longitudinal direction of the input stage coupling region 321 is arranged not to overlap the central axis line extending in the longitudinal direction of the input coupling electrode 40a as seen from the above, and an output stage coupling region 322 is shaped as a strip and the central axis line extending in the longitudinal direction of the output stage coupling region 322 is arranged not to overlap the central axis line extending in the longitudinal direction of the output coupling electrode 40b as seen from the above.

This is to suppress the occurrence of the peak at λ/2 resonance of the resonance electrode coupling-conductor 32 within the use frequency band of UWB and outside the pass bandpassband by weakening a broad side coupling between the input stage coupling region 321 and the input coupling electrode 40a to improve the out-of-band characteristics.

In particular, it is preferable as shown in Fig. 17B that the input stage coupling region 321 is arranged not to overlap the central axis line extending in the longitudinal direction of the input coupling electrode 40a as seen from the above and the output stage coupling region 322 is arranged not to overlap the central axis line extending in the longitudinal direction of the output coupling electrode 40b. By doing so, it may be possible to weaken the coupling between the resonance electrode coupling conductor 32 and the input coupling electrode 40a and the coupling between the resonance electrode coupling conductor 32 and the output coupling electrode 40b while maintaining the coupling between the resonance electrode coupling conductor 32 and the first resonance electrodes 30a, 30b, 30c, and 30d. In addition, even though the input stage coupling region 321 and the resonance electrode 30a of the input stage faces each other, the term "faces" means that there are no protrusions as seen from the above since the input stage coupling region 321 and the resonance electrode 30a of the input stage overlap each other. If there is a protrusion where the input stage coupling region 321 and the resonance electrode 30a of the input stage do not overlap each other, the losses could be increased. This is also true for the relationship between the output stage coupling region 322 and the resonance electrode 30d of the output stage.

### (Eighth Embodiment)

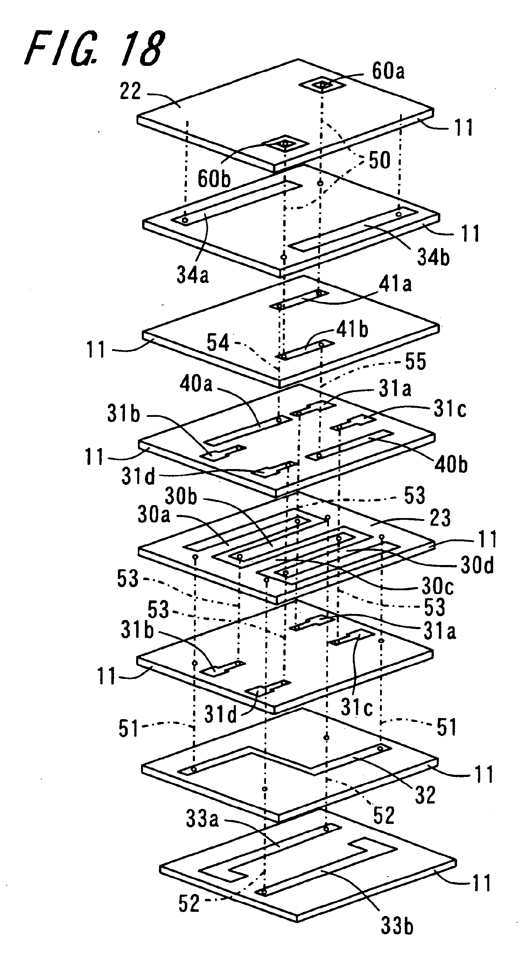

Fig. 18 is an exploded perspective view schematically illustrating a bandpass filter according to an eighth embodiment of the present invention. It is preferable as shown in Fig. 18 that in addition to the structure according to the embodiment shown in Fig. 16, a strip-shaped input coupling resonance electrode 34a electromagnetically coupled with the input coupling electrode 40a and a strip-shaped output coupling resonance electrode 34b electromagnetically coupled with the output coupling electrode 40b, one end of each of the input coupling resonance electrode 34a and the output coupling resonance electrode 34b is connected to the ground potential to function as a 1/4 wavelength resonator, are arranged on the inter-layer portion that is located over the inter-layer portion on which the input coupling electrode 40a and the output coupling electrode 40b are arranged and outside the region between the resonance electrode 30a of the input stage and the resonance electrode 30d of the output stage as seen from the above.

This structure allows the input coupling resonance electrode 34a and the output coupling resonance electrode 34b to function as a counteraction resonator, and therefore, an attenuation pole may be formed separately from the attenuation pole formed by the second resonance electrode. The attenuation pole is expanded at the higher band side without changing the size of the pass bandpassband by adjusting the length of the input coupling resonance electrode 34a and the output coupling resonance electrode 34b, thus making it possible to improve the skirt characteristic (making the skirt characteristic more abrupt).

Here, the input coupling resonance electrode 34a is coupled with the input coupling electrode 40a, and the output coupling resonance electrode 34b is coupled with the output coupling electrode 40b. If the input coupling resonance electrode 34a is positioned within the region between the resonance electrode 30a of the input stage and the resonance electrode 30d of the output stage, the coupling between the input coupling resonance electrode 34a and the input coupling electrode 40a becomes too strong, and this may weaken the coupling between the input coupling electrode 40a and the resonance electrode 30a of the input stage, thus causing the filter characteristics to be lost. If the input coupling resonance electrode 34a goes further deeply inside the region, the input coupling resonance electrode 34a ends up to be coupled with the resonance electrode 30b, also causing the filter characteristics to be lost. In the meanwhile, in a case where the input coupling resonance electrode 34a is located on or under the same inter-layer portion as that on which the input coupling electrode 40a is arranged, the input coupling resonance electrode 34a ends up to be coupled with the resonance electrode 30a, thus causing the filter characteristics to be lost.

This is much the same for the output coupling resonance electrode 34b.

Even though the input coupling resonance electrode 34a and the output coupling resonance electrode 34b are provided in the embodiment in terms of facility in design, it may be possible to provide either one of the input coupling resonance electrode 34a or the output coupling resonance electrode 34b.

### (Ninth Embodiment)

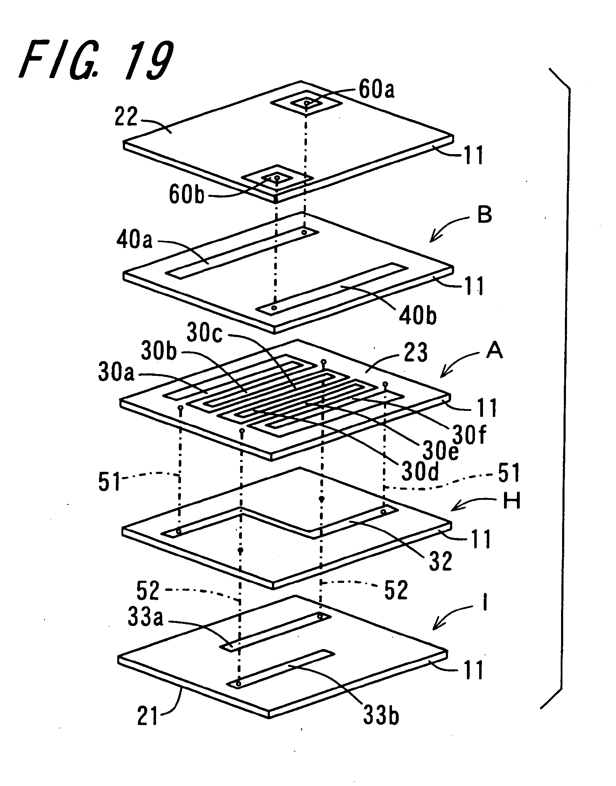

Fig. 19 is an exploded perspective view schematically illustrating a bandpass filter according to a ninth embodiment of the present invention. The difference in the structure from the embodiment shown in Fig. 1 is that the first resonance electrode is configured to have six stages such as 30a, 30b, 30c, 30d, 30e, and 30f.

Even in the bandpass filter according to the fifth embodiment, there is the resonance electrode coupling conductor 32 whose one end is connected to the annular ground electrode 23 near one end (short end) of the resonance electrode 30a of the input stage through the first penetration conductor 51 and the other end is connected to the annular ground electrode 23 near one end (short end) of the resonance electrode 30d of the output stage through the first penetration conductor 51. Therefore, the resonance electrode coupling conductor 32 is adapted to be inductively coupled with the resonance electrode of the input stage and the resonance electrode of the output stage at a portion near one end (short end) of the resonance electrode 30a of the input stage and at a portion near one end of (short end) of the resonance electrode 30d of the output stage. In the meanwhile, a capacitive coupling is made between two adjacent resonance electrodes (between 30a and 30b, between 30b and 30c, between 30c and 30d, between 30d and 30e, and between 30e and 30f) among the six first resonance electrodes. This structure constitutes a so-called pseudo elliptic function filter. Accordingly, an attenuation pole may be formed at the lower band side and an attenuation pole at the higher band side than the pass bandpassband. By doing so, there may be achieved a filter characteristic of being abruptly attenuated at the other bands than the pass bandpassband.

In addition, the pseudo elliptic function filter, for example, a six-stage resonator, may form attenuation poles at the lower band side and the higher band side than the pass bandpassband as long as it has the following relationship: the coupling between the first-stage resonator and the second-stage resonator is positive (+), the coupling between the second-stage resonator and the third-stage resonator is positive (+), the coupling between the third-resonator and the fourth-resonator is positive (+), the coupling between the fourth-stage resonator and the fifth-stage resonator is positive (+), the coupling between the fifth-stage resonator and the sixth-stage resonator is positive (+), and the coupling between the first-stage resonator and the sixth-stage resonator is negative (-). Here, "positive" corresponds to being capacitive and "negative" corresponds to being inductive.

As such, there may be achieved a bandpass filter according to the fifth embodiment, which has an attenuation characteristic of being more abruptly attenuated than the bandpass filter according to the seventh embodiment of the present invention described above.

### (Tenth Embodiment)

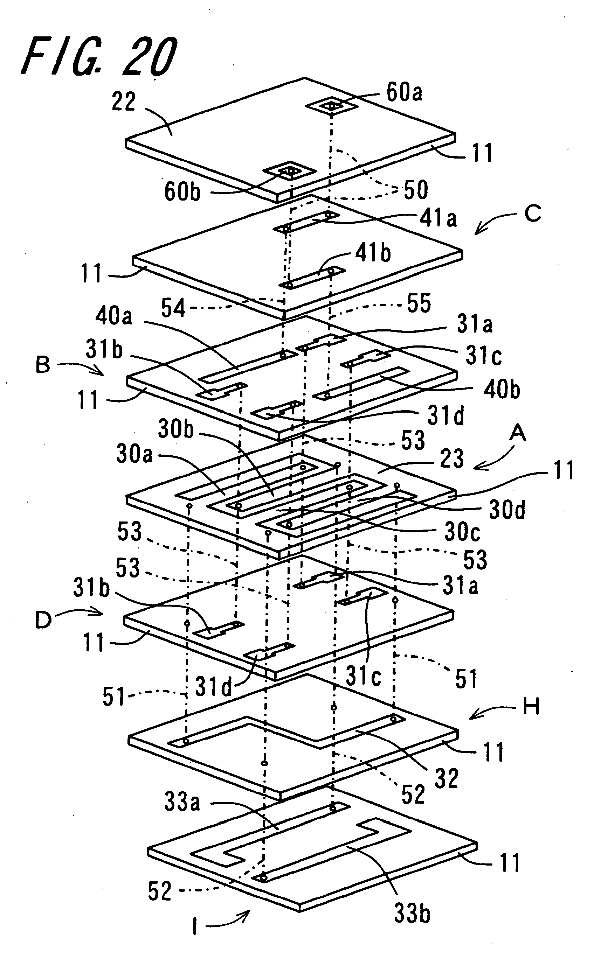

Fig. 20 is an exploded perspective view schematically illustrating a bandpass filter according to a tenth embodiment of the present invention. The difference in structure from the embodiment shown in Fig. 16 is that the auxiliary resonance electrodes 31a, 31b, 31c, and 31d are arranged on the inter-layer portion B located above the inter-layer portion A on which the first resonance electrodes 30a, 30b, 30c, and 30d and the annular ground electrode 23 are arranged, each having a region facing the annular ground electrode 23 and a region facing each of the first resonance electrodes 30a, 30b, 30c, and 30d, and the auxiliary resonance electrodes 31a, 31b, 31c, and 31d are arranged on the inter-layer portion D located under the inter-layer portion A on which the first resonance electrodes 30a, 30b, 30c, and 30d and the annular ground electrode 23 are arranged, each having a region facing the annular ground electrode 23 and a region facing each of the first resonance electrodes 30a, 30b, 30c, and 30d. The first resonance electrodes 30a, 30b, 30c, and 30d and the auxiliary resonance electrodes 31a, 31b, 31c, and 31d are connected to each other through the third penetration conductors 53 that penetrate the dielectric layer 11. By doing so, the capacitance between the auxiliary resonance electrodes 31a, 31b, 31c, and 31d and the annular ground electrode 23 is added, and therefore, the capacitance between the other ends (open ends) of the first resonance electrodes 30a, 30b, 30c, and 30d and the ground potential is further increased, and therefore, the length of the first resonance electrodes 30a, 30b, and 30c may be shortened, thus enabling a smaller-size bandpass filter.

In addition, in the tenth embodiment shown in Fig. 20, each of the auxiliary resonance electrodes 31a, 31b, 31c, and 31d is provided in pair: one at the upper side and one at the lower side. In a case where the it does not matter if the length is less shortened than the above embodiment, however, the auxiliary resonance electrodes 31a, 31b, 31c, and 31d may be configured to be provided either above or under the inter-layer portion A on which the first resonance electrodes 30a, 30b, 30c, and 30d and the annular ground electrode 23 are arranged.

Further, in addition to the formation of the auxiliary resonance electrode 31a and 31d, the auxiliary input coupling electrode 41a and the auxiliary output coupling electrode 41b are formed to correspond to the input coupling electrode 40a and the output coupling electrode 40b, respectively, on the inter-layer portion C different from the inter-layer portion A on which the first resonance electrodes 30a, 30b, 30c, and 30d and the annular ground electrode 23 are arranged and the inter-layer portions B and D on which the auxiliary resonance electrodes 31a, 31b, 31c, and 31d are arranged.

Even though the second resonance electrodes 33a and 33b are formed to be shorter than the first resonance electrodes 30a, 30b, 30c, and 30d in the seventh embodiment shown in Fig. 16, the second resonance electrodes 33a and 33b are lengthened as the first resonance electrodes 30a, 30b, 30c, and 30d are shortened as described above. Therefore, the second resonance electrodes 33a and 33b obtains capacitance between the second resonance electrodes 33a and 33b and the annular ground electrode 23 and are shortened by forming the second resonance electrodes 33a and 33b to have the broad width so that the other end of each of the second resonance electrodes 33a and 33b, which is opposite to one end thereof, which is connected to the ground potential, is protruded toward one side as shown in Fig. 20. The second resonance electrodes 33a and 33b may be formed in various shapes, such as, a shape in which the other end of the second resonance electrode 33a and 33b has been bent or shape of the letter "T".

In adjusting the amount of coupling between the first resonance electrodes and the second resonance electrodes, the second resonance electrode is positioned to be close to the first resonance electrode having an inter-digital relationship therewith to increase the amount of coupling, with the second resonance electrode lengthened more than the first resonance electrode.

Further, even though the second resonance electrode is apparently longer than the first resonance electrode, the resonance frequency of the second resonance electrode is higher than that of the first resonance electrode, and therefore, the second resonance electrode is adapted to have the resonance frequency near the cutoff frequency at the higher band side than the pass bandpassband similarly to the embodiment shown in Fig. 16.

As such, a smaller-size bandpass filter may be achieved according to the tenth embodiment compared to the bandpass filter according to the seventh embodiment.

### (Eleventh Embodiment)

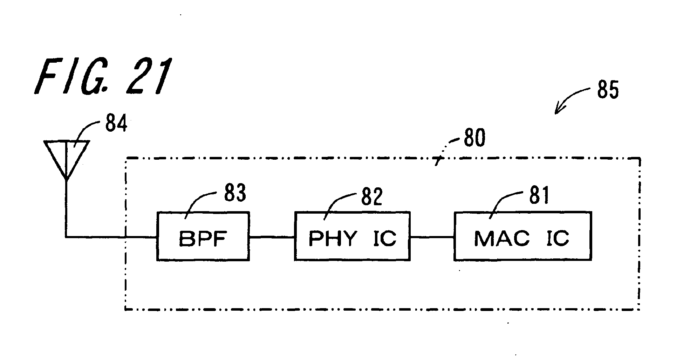

Fig. 21 is a block diagram illustrating a constructional example of a high frequency module 80 and a radio communication device 85 using the high frequency module 80 according to an eleventh embodiment of the present invention, which utilize a bandpass filter according to the present invention. The high frequency module 80 and the radio communication device 85 according to this embodiment may use any one of the bandpass filters according to the first to tenth embodiments of the present invention as described above.

The high frequency module 80 according to the present invention includes an MAC (Medium Access Control) IC 81 that performs medium access control, a PHY (Physical Layer) IC 82 connected to the MAC IC 81 to perform transmission/receipt of a multiband OFDM signal, and a bandpass filter 83 connected to the PHY IC 82. The radio communication device 85 according to the present invention further includes an antenna 84 connected to the bandpass filter 83 of the high frequency module 80. When passing through the bandpass filter 83, a transmission signal outputted from the PHY IC 82 is transmitted through the antenna 84, with signals having frequencies other than a communication band attenuated. When passing through the bandpass filter 83, a receipt signal received through the antenna 84 is entered into the PHY IC 82, with the signals having frequencies other than the communication band attenuated.

The high frequency module 80 and the radio communication device 85 according to the present invention employs in filtering of the transmission signal and receipt signal the bandpass filters according to the present invention that have a low-loss passing signal over the entire regions of the communication band, so that the attenuation of a receipt signal and a transmission signal passing the bandpass filter is reduced, and therefore, the receipt sensitivity is improved, since the amplification degree of the transmission signal and the receipt signal may be reduced, consumption power is lowered in an amplification circuit. Accordingly, it may be possible to achieve a high-capacity high frequency module 80 and the radio communication device 85 that have a high receipt sensitivity and low consumption power.

In the bandpass filters according to the present invention, the dielectric layer 11 may be formed of a resin such as epoxy resin, or ceramics such as dielectric ceramics. For example, a glass-ceramic material may be very appropriately used which is composed of a dielectric ceramic material such as BaTiO₃, Pb₄Fe₂Nb₂O₁₂, TiO₂ and a glass material such as B₂O₃, SiO₂ Al₂O₃, ZnO and may be fireable at a relatively low temperature on the order of 800 to 1200°C. Further, the thickness of the dielectric layer 11 is set, for example, on the order of 0.05 to 0.1 mm.

A conductive material whose principle constituent is an Ag alloy of, for example, Ag, Ag-Pd, and Ag-Pt or Cu-based, W-based, Mo-based, and Pd-based conductive material is fairly appropriately used for the above-described various electrodes and penetration conductors. The thickness of the various electrodes is set, for example, on the order of 0.001 to 0.05 mm.

The bandpass filters according to the present invention may be manufactured, for example, as follows. To begin with, a proper organic solvent is added to ceramic based powder and mixed to form a slurry and then form a ceramic green sheet by a doctor blade method. Next, through-holes for penetration conductors, are formed at the obtained ceramic green sheet using a punching machine, and conductive paste such as Ag, Ag-Pd, Au, and Cu, is filled in the through-holes to form penetration conductors. Thereafter, the above described various electrodes are formed on the ceramic green sheet by lithography. Then, these are stacked and pressurized by a hot press device, and fired at a high temperature of 800 to 1050°C.

### (Variation)

The present invention is not limited to the first to eleventh embodiments, and a diversity of variations and modifications may be made without departing from the scope and spirit of the present invention.

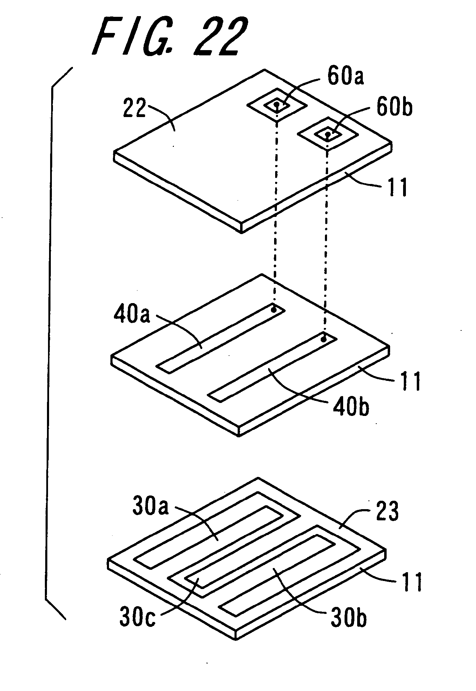

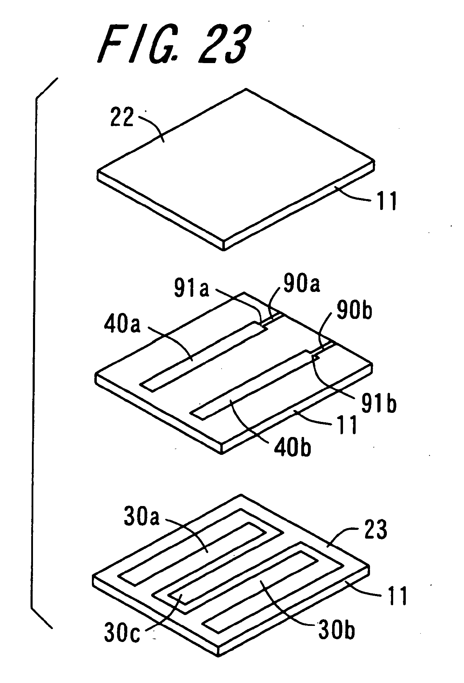

Fig. 22 is an exploded perspective view schematically illustrating a first variation to a bandpass filter according to the present invention. Fig. 23 is an exploded perspective view schematically illustrating a second variation to a bandpass filter according to the present invention, which depicts only the region where the bandpass filter is formed in a case where the bandpass filter according to the present invention is formed on a region of the module substrate.

Further, the following descriptions focus on only the differences from the first embodiments with respect to the variations, wherein the same reference numerals refer to the same constitutional elements, and therefore, the repetitive descriptions will be omitted.

For example, even though an example has been described in the first to third embodiments where the auxiliary resonance electrodes 31a, 31b, and 31c, the auxiliary input coupling electrode 41a, and the auxiliary output coupling electrode 41b are provided, it may be possible, for example, to remove the auxiliary resonance electrodes 31a, 31b, and 31c, the auxiliary input coupling electrode 41a, and the auxiliary output coupling electrode 41b like the bandpass filter shown in Fig. 22. In a case where it does not matter if the planar shape is large-sized, the auxiliary resonance electrodes 31a, 31b, and 31c are not necessary, and in this case it is natural that the auxiliary input coupling electrode 41a and the auxiliary output coupling electrode 41b are also unnecessary.

Even though an example has been described in the first to tenth embodiments where the input terminal electrode 60a and the output terminal electrode 60b are provided, the input terminal electrode 60a and the output terminal electrode 60b are not necessary in a case where the bandpass filter is formed on a region of the module substrate. For example, an input wiring electrode 90a from an external circuit in the module substrate and an output wiring electrode 90b to the external circuit in the module substrate may be directly connected to the input coupling electrode 40a and the output coupling electrode 40b, respectively, like the bandpass filter shown in Fig. 23. In this case, a contact point 91a of the input coupling electrode 40a and the input wiring electrode 90a becomes a gateway through which an electrical signal inputted from the external circuit is supplied to the input coupling electrode 40a, and a contact point 92b of the output coupling electrode 40b and the output wiring electrode 90b becomes a gateway through which an electrical signal outputted to the external circuit is drawn from the output coupling electrode 40b.

Further, even though an example has been described in the above described first to tenth embodiments, where the input coupling electrode 40a, the output coupling electrode 40b, and the auxiliary resonance electrodes 31a, 31b, 31c, and 31d are arranged on the same inter-layer portion of the laminate, the input coupling electrode 40a, the output coupling electrode 40b, and the auxiliary resonance electrodes 31a, 31b, 31c, and 31d may be arranged on the different inter-layer portion, the input coupling electrode 40a and the output coupling electrode 40b may be arranged on the different inter-layer portion, or the auxiliary resonance electrodes 31a, 31b, 31c, and 31d may be arranged on the different inter-layer portions from each other.

Further, even though an example has been described in the first to third, the sixth, and the tenth embodiments where the auxiliary input coupling electrode 41a and the auxiliary output coupling electrode 41b are arranged on the same inter-layer portion C of the laminate 10, the auxiliary input coupling electrode 41a and the auxiliary output coupling electrode 41b may be arranged on the different inter-layer portion of the laminate 10.

Further, even though an example has been described in the first to third embodiments where three resonance electrodes 30a, 30b, and 30c are electromagnetically coupled with each other to constitute a bandpass filter, for example, two, or four or more resonance electrodes may be electromagnetically coupled with each other to constitute a bandpass filter. The number of resonance electrodes may be selected according to required electrical properties and acceptable shape measurements.

Further, even though an example has been described in the above mentioned first to tenth embodiments where the first ground electrode 21 is arranged on the bottom surface of the laminate 10 and the second ground electrode 22 is arranged on the top surface of the laminate 10, an additive dielectric layer may be, for example, arranged under the first ground electrode 21 and an additive dielectric layer may be arranged over the second ground electrode 22.

Even though an example has been described in the eleventh embodiment where the high frequency module 80 is composed of the MAC IC 81 performing medium access control, the PHY IC 82 connected to the MAC IC 81, and the bandpass filter 83 connected to the PHY IC 82, a one-chip IC in which the MAC IC 81 and the PHY IC 82 are integrally formed to each other may be used. Further, the high frequency module may be composed only of the PHY IC 82 and the bandpass filter 83 connected to the PHY IC 82, and the radio communication device 85 may be configured by connecting the MAC IC 81 and the antenna 84 to the high frequency module.

Further, even though a bandpass filter used for UWB has been described, it is needless to say that the bandpass filter of the present invention is also valid for other purposes that require broad bands.

### (Example 1)

Hereinafter, specific examples of electronic elements according to the present invention will be described.

Electrical properties of the bandpass filter having such structures as shown in Figs. 1 to 4 were calculated by simulation using a finite element method. The conditions for calculation was as follows: relative dielectric constant of the dielectric layer 11=9.4, dissipation factor of the dielectric layer 11=0.0005, and conductivity of various electrodes=3.0x10⁷ S/m as physical property values. As the shape measurements, the resonance electrodes 30a, 30b, and 30c were adapted to have the width of 0.4 mm, the length of 2.9 mm, and the interval of 0.13 mm between two adjacent resonance electrodes. The input coupling electrode 40a and the output coupling electrode 40b were adapted to have the width of 0.3 mm and the length of 2.5 mm, and the auxiliary input coupling electrode 41a and the auxiliary output coupling electrode 41b were adapted to have the width of 0.3 mm and the length of 1.45 mm. Each of the auxiliary resonance electrodes 31a, 31b, and 31c was adapted to have a first rectangular portion and a second rectangular portion joined to each other, wherein the first rectangular portion is arranged 0.3 mm away from the other end of each of the resonance electrodes 30a, 30b, and 30c and has the width of 0.45 mm and the length of 0.8 mm, and the second rectangular portion is located from the first rectangular portion toward each of the resonance electrodes 30a, 30b, and 30c and has the width of 0.2 mm and the length of 0.4 mm. Each of the input terminal electrode 60a and the output terminal electrode 60b were adapted to have a square portion whose one edge is 0.3 mm long and to be 0.2 mm away from the second ground electrode 22. In the external appearance, each of the first ground electrode 21, the second ground electrode 22, and the annular ground electrode 23 was adapted to have the width of 3 mm and the length of 5 mm, and the opening portion of the annular ground electrode 23 was adapted to have the width of 2.4 mm and the length of 3 mm. The bandpass filter was overall adapted to have the width of 3 mm, the length of 5 mm, and the thickness of 0.91 mm, and to have the inter-layer portion A at the center thereof in the thickness direction. The interval between the inter-layer portion A and the inter-layer portion B, and the interval between the inter-layer portion B and the inter-layer portion C, respectively, were adapted to be 0.065 mm. The thickness of various electrodes was adapted to be 0.01 mm, and the diameter of various penetration conductors was adapted to be 0.1 mm.

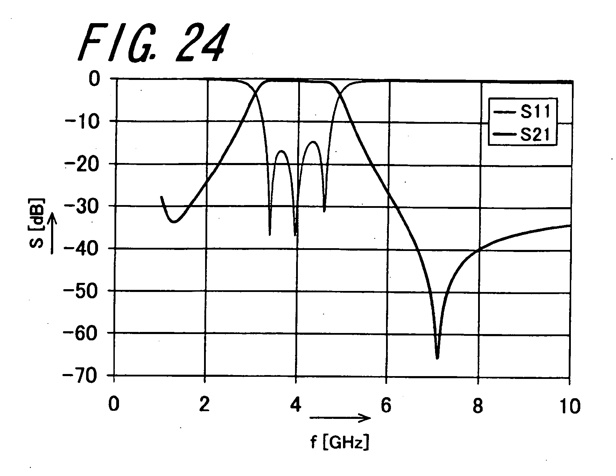

Fig. 24 is a graph illustrating a result of the simulation, wherein horizontal axis refers to frequencies, vertical axis refers to losses, S21 refers to a transmission characteristicstransmission characteristic, and S11 refers to a reflection characteristic. The graph illustrated in Fig. 24 shows the loss of less than 1.5dB occurs in the frequency range of 3.2 GHz to 4.7 GHz that corresponds to 40% by the relative bandwidth, which is even broader than the region realized by the conventional filter using the conventional 1/4 wavelength resonator. As such, it could be possible to achieve an excellent transmission characteristics transmission characteristic of being flat and of low loss over the entire region of the broad pass bandpassband and therefore the effectiveness of the present invention might be verified.

### (Example 2)

The transmission properties of the bandpass filter having the structure according to Fig. 15 were calculated by electromagnetic simulation. The conditions of calculation were as follows: relative dielectric constant of the dielectric layer 11=9.4, dissipation factor=0.0005, and conductivity=3.0×10⁷ S/m. As the shape measurements of the design values used for the trial production, the resonance electrodes 30a, 30b, 03c, and 30d were adapted to have the width of 0.4 mm, the length of 2.85 mm, the interval of 0.15 mm between the resonance electrodes 30a and 30b, and the interval of 0.15 mm between the resonance electrodes 30c and 30d, and the interval of 0.15 mm between the resonance electrodes 30b and 30c. The input coupling electrode 40a and the output coupling electrode 40b were adapted to have the width of 0.3 mm and the length of 2.5 mm, and the auxiliary input coupling electrode 41a and the auxiliary output coupling electrode 41b were adapted to have the width of 0.3 mm and the length of 1.45 mm. Each of the auxiliary resonance electrodes 31a, 31b, 31c, and 31d was adapted to have a first rectangular portion and a second rectangular portion joined to each other, wherein the first rectangular portion is arranged 0.3 mm away from the other end of each of the resonance electrodes 30a, 30b, 30c, and 30d and has the width of 0.45 mm, the length of 0.8 mm, and the second rectangular portion is located from the first rectangular portion toward the resonance electrodes 30a, 30b, 30c, and 30d and has the width of 0.2 mm and the length of 0.4 mm. Each of the input terminal electrode 60a and the output terminal electrode 60b was adapted to have a square portion whose one edge is 0.3 mm long and to be 0.2 mm away from the second ground electrode 22. In the external appearance, each of the first ground electrode 21, the second ground electrode 22, and the annular ground electrode 23 was adapted to have the width of 4 mm and the length of 6 mm, and the opening portion of the annular ground electrode 23 was adapted to have the width of 2.4 mm and the length of 3 mm. The bandpass filter was overall adapted to have the width of 3 mm, the length of 5 mm, and the thickness of 0.9 mm. Each of the interval between the inter-layer portion C on which the auxiliary input coupling electrode 41a and the auxiliary output coupling electrode 41b are arranged and the inter-layer portion B located over the inter-layer portion C and on which the auxiliary resonance electrodes 31a, 31b, 31c, and 31d are arranged was adapted to be 0.065 mm. The thickness of various electrodes was adapted to be 0.013 mm, and the diameter of various penetration conductors was adapted to be 0.1 mm. The resonance electrode coupling conductor was adapted to have the width of 0.2 mm and the central connection portion of 0.1 mm to form the attenuation pole.

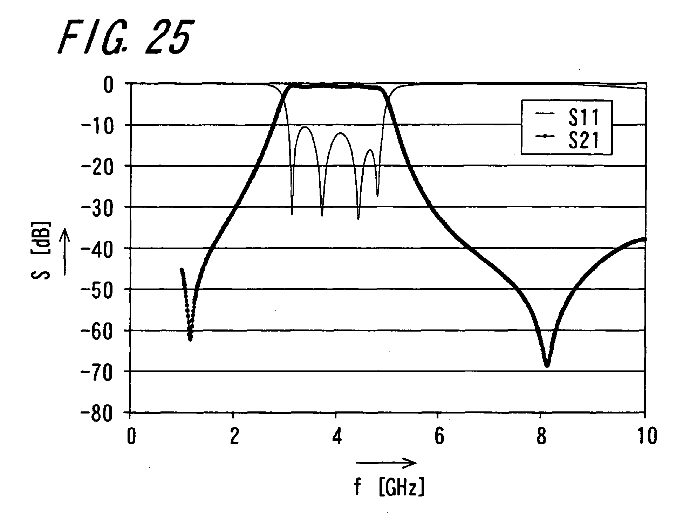

Fig. 25 is a graph illustrating a result of calculation, wherein horizontal axis refers to frequencies, vertical axis refers to losses, S21 refers to a transmission characteristicstransmission characteristic, and S11 refers to a reflection characteristic. Fig. 25 shows that a loss of less than 1.5dB occurs in the frequency range of 3.4 GHz to 4.6 GHz that corresponds to 30% by the relative bandwidth in the transmission characteristics transmission characteristic S21, and an attenuation pole is formed at each of 2.5 GHz and 5.3 GHz other than the pass bandpassband. As such, it can be possible to obtain an excellent transmission characteristicstransmission characteristic of being capable of securing sufficient attenuation at the band other than the pass bandpassband as well as of being flat and of low loss over the entire region of the broad pass bandpassband therefore the effectiveness of the present invention might be verified.

In the meanwhile, the transfer properties of the bandpass filter having the construction without the resonance electrode coupling conductor 32 shown in Fig. 15 were calculated by electromagnetic simulation. The conditions for calculation were as follows: relative dielectric constant of the dielectric layer 11=9.4, dissipation factor=0.0005, and conductivity=3.0×10⁷ S/m. As the shape measurements of design values for the trial production, the resonance electrodes 30a, 30b, 30c, and 30d were adapted to have the width of 0.4 mm, the length of 2.85 mm, the interval of 0.15 mm between the resonance electrode 30a and the resonance electrode 30b, and the interval of 0.15 mm between the resonance electrode 30c and the resonance electrode 30d, and the interval of 0.20 mm between the resonance electrode 30b and the resonance electrode 30c. Each of the input coupling electrode 40a and the output coupling electrode 40b was adapted to have the width of 0.3 mm and the length of 2.5 mm, and each of the auxiliary input coupling electrode 41a and the auxiliary output coupling electrode 41b was adapted to have the width of 0.3 mm and the length of 1.45 mm. Each of the auxiliary resonance electrodes 31a, 31b, 31c, and 31d was adapted to have a first rectangular portion and a second rectangular portion joined to each other, wherein the first rectangular portion is arranged 0.3 mm away from the other end of each of the resonance electrodes 30a, 30b, 30c, and 30d and has the width of 0.45 mm and the length of 0.8 mm, and the second rectangular portion is located from the first rectangular portion toward each of the resonance electrodes 30a, 30b, 30c, and 30d and has the width of 0.2 mm and the length of 0.4 mm. Each of the input terminal electrode 60a and the output terminal electrode 60b was adapted to have a square portion whose one edge is 0.3 mm and to be 0.2 mm away from the second ground electrode 22. In the external appearance, each of the first ground electrode 21, the second ground electrode 22, and the annular ground electrode 23 was adapted to have the width of 4 mm and the length of 6 mm, and the opening portion of the annular ground electrode 23 was adapted to have the width of 3 mm and the length of 3 mm. The bandpass filter was overall adapted to have the width of 3 mm, the length of 5 mm, and the thickness of 0.9 mm. The interval between the inter-layer portion B and the inter-layer portion C was adapted to be 0.065 mm. The thickness of various electrodes was adapted to be 0.013 mm, and the diameter of various penetration conductors was adapted to be 0.1 mm.

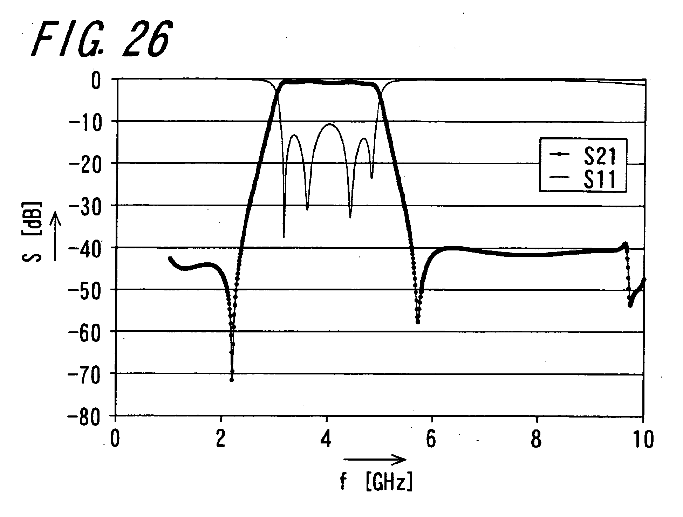

Fig. 26 is a graph illustrating a result of calculation, wherein horizontal axis refers to frequencies, vertical axis refers to losses, S21 refers to a transmission characteristicstransmission characteristic, and S11 refers to a reflection characteristic. It could be seen in Fig. 26 that attenuation is smooth at the bands other than the pass bandpassband and the attenuation is sufficiently not secured.

### (Example 3)

The transfer characteristics of the bandpass filter having the construction shown in Fig. 20 were calculated by electromagnetic simulation. The conditions for calculation were as follows: relative dielectric constant of the dielectric layer 11=9.4, dissipation factor=0.0005, and conductivity=3.0×10⁷ S/m. As the shape measurements of design values used for the trial production, the uppermost layer and the lowermost layer among the seven layers were adapted to have the thickness of 0.3 mm and the other layers were adapted to have the thickness of 0.075 mm as the thickness of the dielectric layer 11. Further, each of the first resonance electrodes 30a, 30b, 30c, and 30d was adapted to have the width of 0.4 mm, the length of 2.85 mm, the interval of 0.15 mm between the first resonance electrode 30a (resonance electrode of input stage) and the first resonance electrode 30b and between the first resonance electrode 30c and the first resonance electrode 30d (resonance electrode of output stage), and the interval of 0.14 mm between the resonance electrode 30b and the resonance electrode 30c. Each of the input coupling electrode 40a and the output coupling electrode 40b was adapted to have the width of 0.3 mm and the length of 2.5 mm and each of the auxiliary input coupling electrode 41a and the auxiliary output coupling electrode 41b was adapted to have the width of 0.3 mm and the length of 1.45 mm. Each of the auxiliary resonance electrodes 31a, 31b, 31c, and 31d was adapted to have a first rectangular portion and a second rectangular portion, wherein the first rectangular portion is arranged 0.3 mm away from the other end of each of the resonance electrodes 30a, 30b, 30c, and 30d and has the width of 0.45 mm and the length of 0.8 mm, and the second rectangular portion is located from the first rectangular portion toward each of the resonance electrodes 30a, 30b, and 30c and has the width of 0.2 mm and the length of 0.4 mm. Each of the input terminal electrode 60a and the output terminal electrode 60b was adapted to have a square portion whose one edge is 0.3 mm long, and to be 0.2 mm away from the second ground electrode 22. In the external appearance, each of the first ground electrode 21, the second ground electrode 22, and the annular ground electrode 23 was adapted to have the width of 3 mm and the length of 5 mm, and the opening portion of the annular ground electrode 23 was adapted to have the width of 2.4 mm and the length of 3 mm. The bandpass filter was overall adapted to have the width of 3 mm, the length of 5 mm, and the thickness of 0.975 mm. The interval between the inter-layer portion C on which the auxiliary input coupling electrode 41a and the auxiliary output coupling electrode 41b are arranged and the inter-layer portion B located over the inter-layer portion C and on which the auxiliary resonance electrodes 31a, 31b, 31c, and 31d are arranged was adapted to be 0.065 mm. The thickness of various electrodes was adapted to be 0.013 mm, and the diameter of various penetration conductors was adapted to be 0.1 mm. The resonance electrode coupling conductor for forming the attenuation pole was adapted to have the width of 0.3 mm at the input stage coupling region and the output stage coupling region, and the width of 0.1 mm at the connection region.

Further, each of the second resonance electrode 33a and 33b, which operate as a counteraction resonator, were shaped to have a strip-shaped region having the width of 0.1 mm and the length of 3.4 mm and a broad-width region (the width is 0.4 mm and the length is 0.36 mm) that is protruded from the other end of the strip-shaped region toward one side. The second resonance electrode 33a is positioned at a location spaced by 0.03 mm from a location of the second resonance electrode 33a when an edge of the second resonance electrode 33a overlaps an edge of the first resonance electrode 30b, which is located in the vicinity of the resonance electrode 30a of the input stage, as seen from the above, so that the second resonance electrode 33a is adjacent to the resonance electrode 30a of the input stage. Similarly, the second resonance electrode 33b is positioned at a location spaced by 0.03 mm from a location of the second resonance electrode 33b when an edge of the second resonance electrode 33b overlaps an edge of the first resonance electrode 30c, which is located in the vicinity of the resonance electrode 30d of the output stage, as seen from the above, so that the second resonance electrode 33b is adjacent to the resonance electrode 30d of the output stage.

Fig. 27 is a graph illustrating a result of calculation, wherein horizontal axis refers to frequencies, vertical axis refers to losses, S21 refers to a transmission characteristicstransmission characteristic, and S11 refers to a reflection characteristic. Fig. 27 shows that a loss of less than 1.5dB occurs in the frequency range of 3.4 GHz to 4.6 GHz that corresponds to 30% by the relative bandwidth in the a transmission characteristicstransmission characteristic S21, and one attenuation pole is formed at 2.5 GHz and two attenuation poles are formed at 5.3 GHz. Further, abrupt increase between the attenuation poles at the high band is also suppressed. As such, it may be possible to obtain an excellent transmission characteristicstransmission characteristic of securing sufficient attenuation at the frequency bands other than the pass bandpassband as well as being flat and of low loss over the entire region of the broad pass bandpassband.

In the meanwhile, measurement was made with respect to the second resonance electrodes 33a and 33b having the same structure as above, but their locations have been changed. Here, the second resonance electrode 33a is positioned at a location spaced by 0.03 mm from a location of the second resonance electrode 33a when an edge of the second resonance electrode 33a overlaps an edge of the first resonance electrode 30b, which is located in the vicinity of the resonance electrode 30a of the input stage, as seen from the above, so that the second resonance electrode 33a is away from the resonance electrode 30a of the input stage. Similarly, the second resonance electrode 33b is positioned at a location spaced by 0.03 mm from a location of the second resonance electrode 33b when an edge of the second resonance electrode 33b overlaps an edge of the first resonance electrode 30c, which is located in the vicinity of the resonance electrode 30d of the output stage, as seen from the above, so that the second resonance electrode 33b is away from the resonance electrode 30d of the output stage.

Fig. 28 is a graph illustrating a result of measurement, wherein horizontal axis refers to frequencies, vertical axis refers to losses, S21 refers to a transmission characteristicstransmission characteristic, and S11 refers to a reflection characteristic. The graph illustrated in Fig. 28 shows that one attenuation pole is formed at 2.5HGz and two attenuation poles are formed at 5.3 GHz other than the pass bandpassband in the transmission characteristicstransmission characteristic S21, an abrupt attenuation characteristic may be obtained near the cutoff frequency similarly to the characteristic shown in Fig. 27, but sharp increase appears between the attenuation poles at the higher band than near the cutoff frequency, and the characteristic is slightly poorer than the characteristic shown in Fig. 27. Accordingly, it can be seen that the second resonance electrode needs to be positioned to remove the sharp increase.

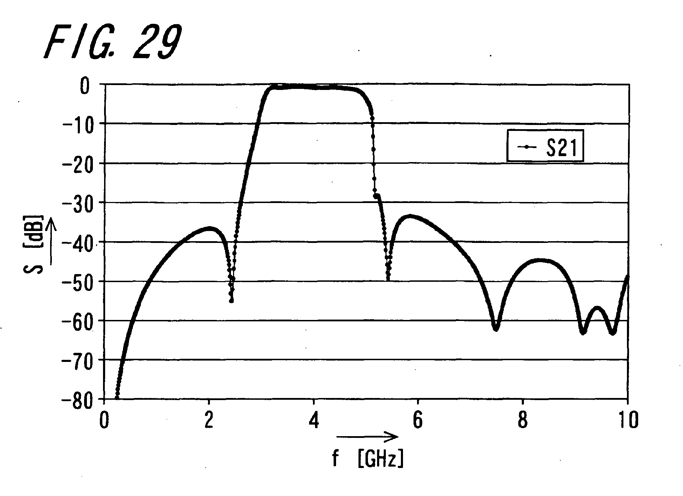

Further, Figs. 27 and 28 showed that the resonance peak appeared and the out-of-band properties were deteriorated near 9 GHz. It is preferable to improve this situation since this band is also included in the use frequency for UWB. Accordingly, the resonance electrode coupling conductor 32 was arranged so that the input stage coupling region 321 and the output stage coupling region 322 are located outside the central axis of the resonance electrode 30a of the input stage and the resonance electrode 30d of the output stage, respectively, as shown in Figs. 17A and 17B. Other parameters such as dimensions regarding the fundamental structure were adapted to have the same parameters as in the structures according to the above examples. A result of calculation was shown in Fig. 29. As a consequence, out-of-band properties up to 10 GHz might be improved less than 30dB.

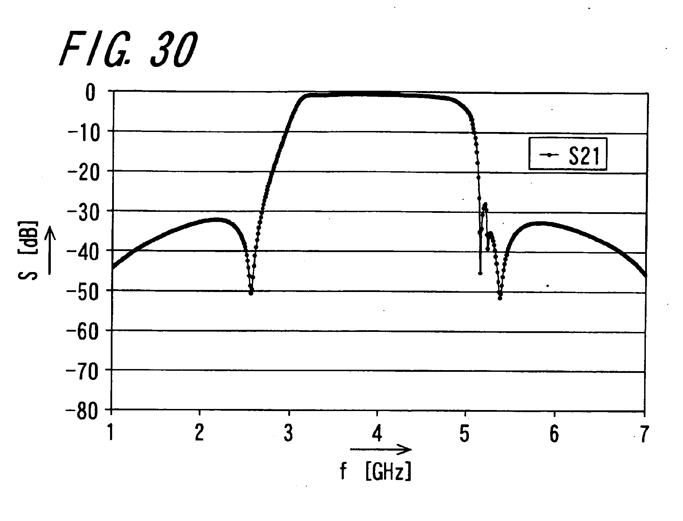

Further, Fig. 30 shows a result of calculation of the transfer properties S21 obtained by performing simulation on the structure shown in Fig. 18, wherein parameters such as dimensions regarding the fundamental structure were adapted to have the same parameters as in the structures according to the above examples. Further, in the structure shown in Fig. 18, the input coupling resonance electrode 34a is located over the input coupling electrode 40a and outside the region on which the first resonance electrodes 30a, 30b, 30c, and 30d are arranged, and the output coupling resonance electrode 34b is located over the output coupling electrode 40b and outside the region on which the first resonance electrodes 30a, 30b, 30c, and 30d are arranged. A new attenuation pole is created near 5 GHz, so that a further abrupt skirt characteristic may be obtained.

The transfer characteristic was calculated by electromagnetic simulation on the structure where the second resonance electrode has been removed from the structure shown in Fig. 20. The conditions of calculation were as follows: relative dielectric constant of the dielectric layer 11=9.4, dissipation factor=0.0005, and conductivity=3.0×10⁷ S/m. As the shape measurements of design values used for the trial production, each of the uppermost and lowermost layers among the six layers of the dielectric layer 11 were adapted to have the thickness of 0.3 mm and the other layers were adapted to have the thickness of 0.075 mm. Each of the first resonance electrodes 30a, 30b, 30c, and 30d was adapted to have the width of 0.4 mm, the length of 2.85 mm, and the interval of 0.15 mm between the first resonance electrode 30a (resonance electrode of input stage) and the first resonance electrode 30b and between the first resonance electrode 30c and the first resonance electrode 30d (resonance electrode of the output stage), and the interval of 0.15 mm between the first resonance electrode 30b and the first resonance electrode 30c. Each of the input coupling electrode 40a and the output coupling electrode 40b was adapted to have the width of 0.3 mm and the length of 2.5 mm, and each of the auxiliary input coupling electrode 41a and the auxiliary output coupling electrode 41b was adapted to have the width of 0.3 mm and the length of 1.45 mm. Each of the auxiliary resonance electrodes 31a, 31b, 31c, and 31d was adapted to have a first rectangular portion and a second rectangular portion joined to each other, wherein the first rectangular portion is arranged 0.3 mm away from the other end of each of the resonance electrodes 30a, 30b, 30c, and 30d and has the width of 0.45 mm and the length of 0.8 mm, and the second rectangular portion is located from the first rectangular portion toward each of the resonance electrodes 30a, 30b, 30c, and 30d, and has the width of 0.2 mm and the length of 0.4 mm. Each of the input terminal electrode 60a and the output terminal electrode 60b was adapted to have a square portion whose one edge is 0.3 mm long and to be 0.2 mm away from the second ground electrode 22. In the external appearance, each of the first ground electrode 21, the second ground electrode 22, and the annular ground electrode 23 was adapted to have the width of 4 mm and the length of 6 mm, and the opening portion of the annular ground electrode 23 was adapted to have the width of 2.4 mm and the length of 3 mm. The bandpass filter was overall adapted to have the width of 3 mm, the length of 5 mm, and the thickness of 0.9 mm. The interval between the inter-layer portion C on which the auxiliary input coupling electrode 41a and the auxiliary output coupling electrode 41b are arranged and the inter-layer portion B located above the inter-layer portion C and on which the auxiliary resonance electrodes 31a, 31b, 31c, and 31d are arranged was adapted to be 0.065 mm. The thickness of various electrodes was adapted to be 0.013 mm, and the diameter of various penetration conductors was adapted to be 0.1 mm. The resonance electrode coupling conductor for forming the attenuation poles was adapted to have the width of 0.2 mm at the input stage coupling region and the output stage coupling region and the width of 0.1 mm at the connection region.

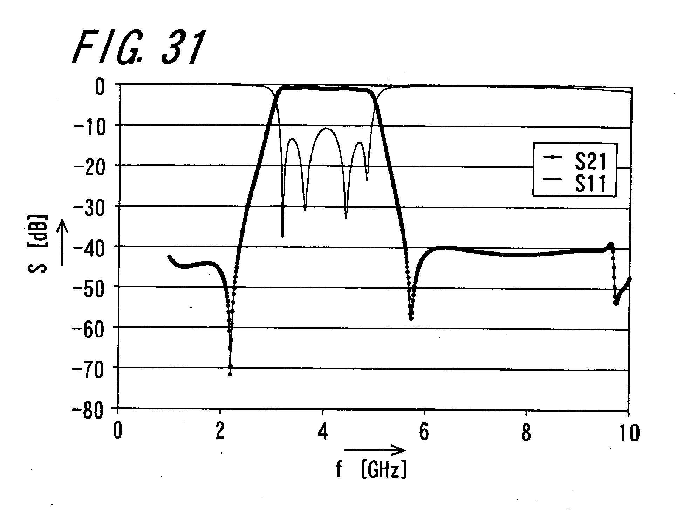

Fig. 31 is a graph illustrating a result of calculation, wherein horizontal axis refers to frequencies, vertical axis refers to losses, S21 refers to a transmission characteristicstransmission characteristic, and S11 refers to a reflection characteristic. Fig. 31 shows that a loss of less than 1.5dB occurs in the frequency range of 3.4 GHz to 4.6 GHz that corresponds to 30% by the relative bandwidth in the transmission characteristicstransmission characteristic S21, and an attenuation pole is formed at each of 2.5 GHz and 5.3 GHz other than the pass bandpassband. As such, it can be seen that it may be possible to obtain an excellent transmission characteristicstransmission characteristic of securing sufficient attenuation at the frequency band other than the pass bandpassband as well as being flat and of low loss over the entire region of the broad pass bandpassband, however, it fails to provide abrupt attenuation compared to the present invention.

Accordingly, the effectiveness of the present invention having the second resonance electrode might be verified.

## Claims

1. A bandpass filter, comprising:
a laminate formed by stacking a plurality of dielectric layers (11);
a first ground electrode (21) arranged on a bottom surface of the laminate connectable to a ground potential;
a second ground electrode (22) arranged on a top surface of the laminate connectable to the ground potential;
a plurality of strip-shaped first resonance electrodes (30a-30d) arranged in parallel with each other on a first layer of the plurality of layers, to be electromagnetically coupled with each other, one end of each of the first resonance electrodes (30a-30d) being connected to the ground potential so that the first resonance electrodes operates as a 1/4 wavelength resonator;
a strip-shaped input coupling electrode (40a) arranged on a second layer of the plurality of layers, so as to be electromagnetically coupled with one of the first resonance electrodes forming an input stage (30a);
a strip-shaped output coupling electrode (40b) arranged on said second layer so as to be electromagnetically coupled with one of the first resonance electrodes forming an output stage (30b), wherein the first resonance electrode forming the output stage (30b) is different from the first resonance electrode forming the input stage (30a) further comprising:
an annular ground electrode (23) formed on the first layer to surround the plurality of first resonance electrodes (30a-30d), wherein the one end of each of the plurality of first resonance electrodes (30a-30d) is connected to the annular ground electrode (23) that is connected to the ground potential;
a plurality of auxiliary resonance electrodes (31a-31d), each of which corresponds to each of the plurality of first resonance electrodes (30a-30d), being arranged on said second layer and each having a region over the annular ground electrode (23) and a region over the corresponding one of the first resonance electrodes (30a-30d), wherein the region over each one of the first resonance electrodes (30a-30d) is connected to the other end of the first resonance electrodes through a first penetration conductor (51)
an auxiliary input coupling electrode (41a) arranged on a third layer of the plurality of layers, having a region over one of the auxiliary resonance electrode (31a) connected to said corresponding one of the first resonance electrodes forming the input stage (30a) and a region over the input coupling electrode (40a), wherein the region over the input coupling electrode (40a) is connected to a portion of the input coupling electrode (40a), which is nearer the other end of said one of the first resonance electrodes of the input stage (30a) than a center of the input coupling electrode (40a) in the longitudinal direction, through a second penetration conductor (52a); and
an auxiliary output coupling electrode (41b) arranged on said third layer, having a region over one of the auxiliary resonance electrode (31b) connected to the corresponding first resonance electrode of the output stage (30b) and a region over the output coupling electrode (40b), wherein the region over the output coupling electrode (40b) is connected to a portion of the output coupling electrode (40b), which is nearer the other end of the first resonance electrode of the output stage (30b) than a center of the output coupling electrode (40b) in the longitudinal direction through a third penetration conductor (52b) wherein
the plurality of first resonance electrodes (30a-30d) are arranged so that one end of one first resonance electrode is alternate to the other end of another electrode neighbored to the one first resonance electrode,
the input coupling electrode (40a) is arranged to be in parallel over the first resonance electrodes of the input stage over more than half of the length of the first resonance electrodes of the input stage,
a position where an electrical signal is supplied is located closer to the other end of the first resonance electrode of the input stage than the center of the input coupling electrode (40a) in the longitudinal direction,
the output coupling electrode (40b) is arranged to be in parallel and over the first resonance electrode of the output stage over more than half of the length of the first resonance electrode of the output stage, and
a position where an electrical signal is drawn is located closer to the other end of the first resonance electrode of the output stage than the center of the output coupling electrode (40b) in the longitudinal direction.

2. The bandpass filter according to claim 1, further comprising:
a resonance electrode coupling conductor (32) arranged on fourth layer of the plurality of layers, one end of which is connected to the ground potential near the one end of the first resonance electrode of the input stage (30a) through one fourth penetration conductor (51), and the other end of which is connected to the ground potential near the one end of the first resonance electrode of the output stage (30b) through another fourth penetration conductor (51), the resonance electrode coupling conductor (32) having a region facing the first layer to be electromagnetically coupled with the first resonance electrode of the input stage and the first resonance electrode of the output stage in a nearly uniform manner, wherein
the plurality of strip-shaped first resonance electrodes (30a-30d) comprises four or more resonance electrodes.

3. The bandpass filter according to claim 2, wherein
the resonance electrode coupling conductor (32) comprises:
an input stage coupling region (321) being paralell and over the first resonance electrode of the input stage (30a),
an output stage coupling region (322) being paralell and over the first resonance electrode of the output stage (30b), and
a connection region (323) connecting the input stage coupling region and the output stage coupling region to be perpendicular to each other.

4. The bandpass filter according to claim 2 or 3, further comprising:
one or more second resonance electrodes (33a, 33b) arranged on a fifth layer of the plurality of layers, to be parallel with the four or more electrodes of the plurality of strip-shaped first resonance electrodes (30a-30d), one end of which is connected to the ground potential through a fifth penetration conductor (52), the second resonance electrode (33a, 33b) being shaped as a strip to have a different length from that of the four or more electrodes of the plurality of strip-shaped first resonance electrodes, the second resonance electrode having a resonance frequency near a cutoff frequency outside a pass bandpassband.

5. The bandpass filter according to claim 4, wherein
an even number of the first resonance electrodes (30a-30d) is provided,
an even number of the second resonance electrodes (33a, 33b) is provided,
the second resonance electrodes (33a, 33b) are in point symmetry with respect of an intersection point of a line connecting one end of the first resonance electrode of the input stage with one end of the first resonance electrode of the output stage and a line connecting the other end of the first resonance electrode of the input stage and the other end of the first resonance electrode of the output stage by viewing from top surface of the laminate.

6. A high frequency module comprising:
the bandpass filter (83) according to claim 1.

7. The module according to claim 6, further comprising:
a Physical Layer IC (82) connected to the bandpass filter (83) to perform transmission/receipt of a multiband OFDM signal, and
an Medium Access Control IC (81) connected to the Physical Layer IC (82) to performs medium access control.

8. A radio communication device comprising:
the bandpass filter (83) according to claim 1 or the high frequency module (80) according to claim 6 or 7.

9. The device according to claim 8, further comprising:
an antenna (84) connected to the bandpass filter (83).

## Patentansprüche

1. Bandpassfilter mit:
einem Laminat, das durch Stapeln mehrerer dielektrischer Schichten (11) gebildet ist;
einer ersten Masseelektrode (21), die auf einer Unterseite des Laminats angeordnet ist, das mit einem Massepotenzial verbunden werden kann;
einer zweiten Masseelektrode (22), die auf einer Oberseite des Laminats angeordnet ist, das mit dem Massepotenzial verbunden werden kann;
mehreren streifenförmigen ersten Resonanzelektroden (30a-30d), die parallel zueinander auf einer ersten Schicht der mehreren Schichten angeordnet sind, um mit einander elektromagnetisch gekoppelt zu sein, wobei ein Ende von jeder der ersten Resonanzelektroden (30a-30d) mit dem Massepotenzial verbunden ist, so dass die ersten Resonanzelektroden als Viertelwellenlängenresonator arbeiten;
einer streifenförmigen Eingabekopplungselektrode (40a), die auf einer zweiten Schicht der mehreren Schichten angeordnet ist, so dass sie elektromagnetisch mit einer der ersten Resonanzelektroden gekoppelt ist, die eine Eingabestufe (30a) bilden;
einer streifenförmigen Ausgabekopplungselektrode (40b), die auf der zweiten Schicht angeordnet ist, so dass sie elektromagnetisch mit einer der ersten Resonanzelektroden gekoppelt ist, die eine Ausgabestufe (30b) bilden, wobei sich die erste Resonanzelektrode, die die Ausgabestufe (30b) bildet, von der ersten Resonanzelektrode, die die Eingabestufe (30a) bildet, unterscheidet,
weiterhin mit:
einer ringförmigen Masseelektrode (23), die auf der ersten Schicht ausgebildet ist, um die mehreren ersten Resonanzelektroden (30a-30d) zu umgeben, wobei das eine Ende von jeder der mehreren ersten Resonanzelektroden (30a, 30d) mit der ringförmigen Masseelektrode (23) verbunden ist, die mit dem Massepotenzial verbunden ist;
mehreren Hilfsresonanzelektroden (31a-31d), von denen jede jeder der mehreren ersten Resonanzelektroden (30a-30d) entspricht, die auf der zweiten Schicht angeordnet sind und jeweils einen Bereich über der ringförmigen Masseelektrode (23) und einen Bereich über der entsprechenden einen der ersten Resonanzelektroden (30a-30d) aufweisen, wobei der Bereich über jeder der ersten Resonanzelektroden (30a-30d) mit dem anderen Ende der ersten Resonanzelektroden durch einen ersten Penetrationsleiter (51) verbunden ist,
einer Hilfseingabe-Kopplungselektrode (41a), die auf einer dritten Schicht der mehreren Schichten angeordnet ist, die einen Bereich über einer der Hilfsresonanzelektrode (31a) hat, die mit der entsprechenden einen der ersten Resonanzelektroden verbunden ist, welche die Eingabestufe (30a) bilden, und einen Bereich über der Eingabekopplungselektrode (40a) hat, wobei der Bereich über der Eingabekopplungselektrode (40a) mit einem Teil der Eingabekopplungselektrode (40a) verbunden ist, der durch einen zweiten Penetrationsleiter (52a) näher an dem anderen Ende der einen der ersten Resonanzelektroden der Eingabestufe (30a) als einer Mitte der Eingabekopplungselektrode (40a) in Längsrichtung ist; und
einer Hilfsausgabe-Kopplungselektrode (41b), die auf der dritten Schicht angeordnet ist, die einen Bereich über einer der Hilfsresonanzelektrode (31b) hat, die mit der entsprechenden ersten Resonanzelektrode der Ausgabestufe (30b) verbunden ist und einen Bereich über der Ausgabekopplungselektrode (40b) hat, wobei der Bereich über der Ausgabekopplungselektrode (40b) mit einem Teil der Ausgabekopplungselektrode (40b) verbunden ist, der durch einen dritten Penetrationsleiter (52b) näher an dem anderen Ende der ersten Resonanzelektrode der Ausgabestufe (30b) als einer Mitte der Ausgabekopplungselektrode (40b) in Längsrichtung ist, wobei
die mehreren ersten Resonanzelektroden (30a-30d) so angeordnet sind, dass ein Ende der ersten Resonanzelektrode mit dem anderen Ende einer anderen Elektrode, die der einen ersten Resonanzelektrode benachbart ist, abwechselt,
die Eingabekopplungselektrode (40a) so angeordnet ist, dass sie über mehr als der Hälfte der Länge der ersten Resonanzelektroden der Eingabestufe parallel zu und über den ersten Resonanzelektroden der Eingabestufe ist,
eine Position, an der ein elektrisches Signal zugeführt wird, näher an dem anderen Ende der ersten Resonanzelektrode der Eingabestufe als der Mitte der Eingabekopplungselektrode (40a) in Längsrichtung positioniert ist,
die Ausgabekopplungselektrode (40b) so angeordnet ist, dass sie über mehr als der Hälfte der Länge der ersten Resonanzelektrode der Ausgabestufe parallel zu und über der ersten Resonanzelektrode der Ausgabestufe ist, und
eine Position, an der ein elektrisches Signal gezogen wird, näher an dem anderen Ende der ersten Resonanzelektrode der Ausgabestufe als der Mitte der Ausgabekopplungselektrode (40b) in Längsrichtung positioniert ist.

2. Bandpassfilter nach Anspruch 1, weiterhin mit:
einem Resonanzelektroden-Kopplungsleiter (32), der auf einer vierten Schicht von mehreren Schichten angeordnet ist, dessen eines Ende mit dem Massepotenzial nahe dem einen Ende der ersten Resonanzelektrode der Eingabestufe (30a) durch einen vierten Penetrationsleiter (51) verbunden ist und dessen anderes Ende mit dem Massepotenzial nahe dem einen Ende der ersten Resonanzelektrode der Ausgabestufe (30b) durch einen weiteren vierten Penetrationsleiter (51) verbunden ist, wobei der Resonanzelektroden-Kopplungsleiter (32) einen Bereich hat, der der ersten Schicht zugewandt ist, um mit der ersten Resonanzelektrode der Eingabestufe und der ersten Resonanzelektrode der Ausgabestufe fast gleichförmig elektromagnetisch gekoppelt zu sein, wobei die mehreren streifenförmigen ersten Resonanzelektroden (30a-30d) vier oder mehr Resonanzelektroden umfassen.

3. Bandpassfilter nach Anspruch 2, wobei
der Resonanzelektroden-Kopplungsleiter (32) umfasst:
einen Eingabestufen-Kopplungsbereich (321), der parallel zu und über der ersten Resonanzelektrode der Eingabestufe (30a) ist,
einem Ausgabestufen-Kopplungsbereich (322), der parallel zu und über der ersten Resonanzelektrode der Ausgabestufe (30b) ist, und
einen Verbindungsbereich (323), der den Eingabestufen-Kopplungsbereich und den Ausgabestufen-Kopplungsbereich verbindet, so dass sie zueinander senkrecht sind.

4. Bandpassfilter nach Anspruch 2 oder 3, weiterhin mit:
einer oder mehreren zweiten Resonanzelektroden (33a, 33b), die auf einer fünften Schicht der mehreren Schichten angeordnet sind, so dass sie parallel zu den vier oder mehr Elektroden der mehreren streifenförmigen ersten Resonanzelektroden (30a-30d) sind, deren eines Ende mit dem Massepotenzial durch einen fünften Penetrationsleiter (52) verbunden ist, wobei die zweite Resonanzelektrode (33a, 33b) wie ein Streifen geformt ist, um eine unterschiedliche Länge zu derjenigen der vier oder mehr Elektroden der mehreren streifenförmigen ersten Resonanzelektroden zu haben, wobei die zweite Resonanzelektrode eine Resonanzfrequenz nahe einer Grenzfrequenz außerhalb eines Bandpasses hat.

5. Bandpassfilter nach Anspruch 4, wobei:
eine gerade Anzahl der ersten Resonanzelektroden (30a-30d) vorgesehen ist,
eine gerade Anzahl der zweiten Resonanzelektroden (33a, 33b) vorgesehen ist,
die zweiten Resonanzelektroden (33a, 33b) bezüglich eines Schnittpunkts einer Linie, die ein Ende der ersten Resonanzelektrode der Eingabestufe mit einem Ende der ersten Resonanzelektrode der Ausgabestufe verbindet, und einer Linie, die das andere Ende der ersten Resonanzelektrode der Eingabestufe und das andere Ende der ersten Resonanzelektrode der Ausgabestufe verbindet, durch Ansicht von der Oberseite des Laminats in Punktsymmetrie sind.

6. Hochfrequenzmodul mit:
dem Bandpassfilter (83) nach Anspruch 1.

7. Modul nach Anspruch 6, weiterhin mit:
einer Physikalischen-Schicht-IS (82), die mit dem Bandpassfilter (83) verbunden ist, um ein Senden/ Empfangen eines Mehrband-OFDM-Signals durchzuführen, und
einer Übertragungsmittelzugriffs-IS (81), die mit der Physikalischen-Schicht-IS (82) verbunden ist, um einen Übertragungsmittelzugriff durchzuführen.

8. Radiokommunikationsvorrichtung mit:
dem Bandpassfilter (83) nach Anspruch 1 oder dem Hochfrequenzmodul (80) nach Anspruch 6 oder 7.

9. Vorrichtung nach Anspruch 8, weiterhin mit:
einer Antenne (84), die mit dem Bandpassfilter (83) verbunden ist.

## Revendications

1. Filtre passe-bande, comprenant :
un stratifié formé en superposant une pluralité de couches diélectriques (11) ;
une première électrode de terre (21) disposée sur une surface inférieure du stratifié pouvant être reliée à un potentiel de terre ;
une seconde électrode de terre (22) disposée sur une surface supérieure du stratifié pouvant être reliée au potentiel de terre ;
une pluralité de premières électrodes de résonance en forme de bande (30a-30d) disposées parallèlement les unes aux autres sur une première couche de la pluralité de couches pour être couplées électromagnétiquement les unes aux autres, une première extrémité de chacune des premières électrodes de résonance (30a-30d) étant reliée au potentiel de terre afin que les premières électrodes de résonance fonctionnent comme un résonateur 1 / 4 d'onde ;
une électrode de couplage d'entrée en forme de bande (40a) disposée sur une deuxième couche de la pluralité de couches pour être couplée électromagnétiquement à l'une des premières électrodes de résonance formant un étage d'entrée (30a) ;
une électrode de couplage de sortie en forme de bande (40b) disposée sur ladite deuxième couche pour être couplée électromagnétiquement à l'une des premières électrodes de résonance formant un étage de sortie (30b),
dans lequel la première électrode de résonance formant un étage de sortie (30b) est différente de la première électrode de résonance formant l'étage d'entrée (30a),
comprenant en outre :
une électrode de terre annulaire (23) formée sur la première couche pour entourer la pluralité de premières électrodes de résonance (30a-30d), la première extrémité de chaque électrode de la pluralité de premières électrodes de résonance (30a-30d) étant reliée à l'électrode de terre annulaire (23) qui est reliée au potentiel de terre ;
une pluralité d'électrodes de résonance auxiliaires (31a-31d), chacune d'entre elles correspondant à chaque électrode de la pluralité de premières électrodes de résonance (30a-30d), disposées sur ladite seconde couche et possédant chacune une zone sur l'électrode de terre annulaire (23) et une zone sur l'électrode correspondante parmi les premières électrodes de résonance (30a-30d), la zone sur chacune des premières électrodes de résonance (30a-30d) étant reliée à la seconde extrémité des premières électrodes de résonance par le biais d'un premier résonateur de pénétration (51),
une électrode de couplage d'entrée auxiliaire (41a) disposée sur une troisième couche de la pluralité de couches, possédant une zone sur l'électrode de résonance auxiliaire (31a) reliée à ladite électrode correspondante parmi les premières électrodes de résonance formant l'étage d'entrée (30a) et une zone sur l'électrode de couplage d'entrée (40a), la zone sur l'électrode de couplage d'entrée (40a) étant reliée à une partie de l'électrode de couplage d'entrée (40a), qui est plus proche de la seconde extrémité de ladite première électrode de résonance de l'étagz d'entrée (30a) qu'un centre de l'électrode de couplage d'entrée (40a) dans la direction longitudinale, par le biais d'un deuxième conducteur de pénétration (52a) ; et
une électrode de couplage de sortie auxiliaire (41b) disposée sur ladite troisième couche, possédant une zone sur l'électrode de résonance auxiliaire (31b) reliée à la première électrode de résonance correspondante de l'étage de sortie (30b) et une zone sur l'électrode de couplage de sortie (40b), reliée à une partie de l'électrode de couplage de sortie (40b), qui est plus proche de la seconde extrémité de la première électrode de résonance de l'étage de sortie (30b) qu'un centre de l'électrode de couplage de sortie (40b) dans la direction longitudinale par le biais d'un troisième conducteur de pénétration (52b),
la pluralité de premières électrodes de résonance (30a-30d) étant disposée de telle sorte qu'une première extrémité d'une première électrode de résonance alterne avec la seconde extrémité d'une autre électrode voisine de ladite première électrode de résonance,
l'électrode de couplage d'entrée (40a) est disposée parallèlement aux premières électrodes de résonance de l'étage d'entrée et sur plus de la moitié de la longueur des premières électrodes de résonance de l'étage d'entrée,
une position où un signal électrique est prévu est située plus près de l'autre extrémité de la première électrode de résonance de l'étage d'entrée que le centre de l'électrode de couplage d'entrée (40a) dans la direction longitudinale,
l'électrode de couplage de sortie (40b) est disposée parallèlement à la première électrode de résonance de l'étage de sortie et sur plus de la moitié de la longueur de la première électrode de résonance de l'étage de sortie, et
une position où un signal électrique est fourni est située plus près de la seconde extrémité de la première électrode de résonance de l'étage de sortie que le centre de l'électrode de couplage de sortie (40b) dans la direction longitudinale.

2. Le filtre passe-bande selon la revendication 1, comprenant en outre :
un conducteur de couplage d'électrode de résonance (32) disposé sur une quatrième couche de la pluralité de couches, dont une première extrémité est reliée au potentiel de terre près de la première extrémité de la première électrode de résonance de l'étage d'entrée (30a) par le biais d'un quatrième conducteur de pénétration (51), et dont la seconde extrémité est reliée au potentiel de terre près de la première extrémité de la première électrode de résonance de l'étage de sortie (30b) par le biais d'un quatrième conducteur de pénétration (51), le conducteur de couplage d'électrode de résonance (32) possédant une zone face à la première couche devant être couplée électromagnétiquement à la première électrode de résonance de l'étage d'entrée et à la première électrode de résonance de l'étage de sortie d'une manière presque uniforme, la pluralité de premières électrodes de résonance en forme de bande (30a-30d) comprenant quatre électrodes de résonance ou plus.

3. Le filtre passe-bande selon la revendication 2, dans lequel
le conducteur de couplage d'électrode de résonance (32) comprend :
une zone de couplage d'étage d'entrée (321) disposée parallèlement à la première électrode de résonance de l'étage d'entrée (30a) et sur celle-ci,
une zone de couplage d'étage de sortie (322) disposée parallèlement à la première électrode de résonance de l'étage de sortie (30b) et sur celle-ci, et
une zone de connexion (323) reliant la zone de couplage d'étage d'entrée et la zone de couplage d'étage de sortie qui doivent être perpendiculaires l'une à l'autre.

4. Filtre passe-bande selon une des revendications 2 ou 3, comprenant en outre :
une ou plusieurs secondes électrodes de résonance (33a, 33b) disposées sur une cinquième couche de la pluralité de couches pour être parallèles aux quatre électrodes ou plus de la pluralité de premières électrodes de résonance en forme de bande (30a-30b), dont une première extrémité est reliée au potentiel de terre par le biais d'un cinquième conducteur de pénétration (52), la seconde électrode de résonance (33a, 33b) étant formée comme une bande pour avoir une longueur différente de celle des quatre électrodes ou plus de la pluralité de premières électrodes de résonance en forme de bande, la seconde électrode de résonance ayant une fréquence de résonance proche d'une fréquence de coupure à l'extérieur d'une bande passante.

5. Le filtre passe-bande selon la revendication 4, dans lequel
un nombre pair des premières électrodes de résonance (30a-30d) est prévu,
un nombre pair des secondes électrodes de résonance (33a, 33b) est prévu,
les secondes électrodes de résonance (33a, 33b) sont symétriques par rapport à un point d'intersection d'une ligne reliant une première extrémité de la première électrode de résonance de l'étage d'entrée et une première extrémité de la première électrode de résonance de l'étage de sortie et d'une ligne reliant la seconde extrémité de la première électrode de résonance de l'étage d'entrée et la seconde extrémité de la première électrode de résonance de l'étage de sortie en regardant à partir de la surface supérieure du stratifié.

6. Module haute fréquence comprenant :
le filtre passe-bande (83) selon la revendication 1.

7. le module selon la revendication 6, comprenant en outre :
un CI de couche physique (82) relié au filtre passe-bande (83) pour assurer la transmission/réception d'un signal OFDM multi-bande, et
un CI de contrôle d'accès au support (81) relié au CI de couche physique (82) pour assurer le contrôle d'accès au support.

8. Dispositif de radiocommunication comprenant :
le filtre passe-bande (83) selon la revendication 1 ou le module haute fréquence (80) selon la revendication 6 ou 7.

9. Le dispositif selon la revendication 8, comprenant en outre :
une antenne (84) reliée au filtre passe-bande (83).
